(19) **Europäisches Patentamt European Patent Office Office européen des brevets**

(11) **EP 4 648 316 A1**

(12) **EUROPEAN PATENT APPLICATION**
published in accordance with Art. 153(4) EPC

(43) Date of publication:
**12.11.2025 Bulletin 2025/46**

(21) Application number: **23914829.9**

(22) Date of filing: **02.01.2023**

(51) International Patent Classification (IPC):
**H04L 1/00** (2006.01)

(52) Cooperative Patent Classification (CPC):
**H04L 1/00**

(86) International application number:
**PCT/KR2023/000002**

(87) International publication number:
**WO 2024/147363 (11.07.2024 Gazette 2024/28)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **LG Electronics Inc.**
**Yeongdeungpo-gu**
**Seoul 07336 (KR)**
• **Korea Advanced Institute of Science and Technology**
**Daejeon 34141 (KR)**

(72) Inventors:
• **KIM, Bonghoe**
**Seoul 06772 (KR)**
• **HA, Jeongseok**
**Daejeon 34200 (KR)**
• **HAN, Seokju**
**Daejeon 34052 (KR)**

(74) Representative: **Frenkel, Matthias Alexander Wuesthoff & Wuesthoff Patentanwälte und Rechtsanwalt PartG mbB Schweigerstraße 2 81541 München (DE)**

(54) **METHOD, COMMUNICATION DEVICE, PROCESSING DEVICE, AND STORAGE MEDIUM FOR PERFORMING ENCODING, AND METHOD AND COMMUNICATION DEVICE FOR PERFORMING DECODING**

(57) A communication device that encodes an information block for transmission is provided. The communication device: encodes the information block having a size of K on the basis of a polar code having a size of N to determine a bit sequence having a size of N; selects k bit positions among N bit positions in the bit sequence on the basis of a predetermined puncturing pattern; selects, on the basis of a predetermined extension pattern, k intermediate bit values among intermediate bit values generated while encoding the information block on the basis of the polar code having the size of N; and replaces the bit values of the k bit positions in the bit sequence with the k intermediate bit values to generate a codeword having a size of N.

**FIG. 14**

## Description

### TECHNICAL FIELD

The present disclosure relates to a wireless communication system.

### BACKGROUND

A variety of technologies, such as machine-to-machine (M2M) communication, machine type communication (MTC), and a variety of devices demanding high data throughput, such as smartphones and tablet personal computers (PCs), have emerged and spread. Accordingly, the volume of data throughput demanded to be processed in a cellular network has rapidly increased. In order to satisfy such rapidly increasing data throughput, carrier aggregation technology or cognitive radio technology for efficiently employing more frequency bands and multiple input multiple output (MIMO) technology or multi-base station (BS) cooperation technology for raising data capacity transmitted on limited frequency resources have been developed.

As more and more communication devices have required greater communication capacity, there has been a need for enhanced mobile broadband (eMBB) communication relative to legacy radio access technology (RAT). In addition, massive machine type communication (mMTC) for providing various services at anytime and anywhere by connecting a plurality of devices and objects to each other is one main issue to be considered in next-generation communication.

Communication system design considering services/user equipment (UEs) sensitive to reliability and latency is also under discussion. The introduction of next-generation RAT is being discussed in consideration of eMBB communication, mMTC, ultra-reliable and low-latency communication (URLLC), and the like.

### DISCLOSURE

#### Technical Problem

As new radio communication technology has been introduced, the number of UEs to which a BS should provide services in a prescribed resource region is increasing and the volume of data and control information that the BS transmits/receives to/from the UEs to which the BS provides services is also increasing. Since the amount of resources available to the BS for communication with the UE(s) is limited, a new method for the BS to efficiently receive/transmit uplink/downlink data and/or uplink/downlink control information from/to the UE(s) using the limited radio resources is needed. In other words, due to increase in the density of nodes and/or the density of UEs, a method for efficiently using high-density nodes or high-density UEs for communication is needed.

In addition, there is a need for methods for further improving the performance of polar codes, which have been proposed as an alternative to existing channel codes. For example, polar codes achieve channel capacity by using successive cancellation (SC) decoding under the condition of a relatively long length. However, to achieve high error correction performance at finite lengths, list successive cancellation (list-SC) decoding is used. Existing polar codes are designed based on SC decoding to select reliable bit channels for information bits, which results in a degradation of error correction performance in list-SC (or SCL) decoding, compared to SC decoding. Therefore, there is a need to design a polar code that demonstrates improved error correction performance in list-SC (or SCL) decoding.

The objects to be achieved with the present disclosure are not limited to what has been particularly described hereinabove and other objects not described herein will be more clearly understood by persons skilled in the art from the following detailed description.

#### Technical Solution

In an aspect of the present disclosure, provided herein is a method of encoding an information block for transmission in a wireless communication system.

In another aspect of the present disclosure, provided herein is a communication device configured to encode an information block for transmission in a wireless communication system. The communication device includes: at least one transceiver; at least one processor; and at least one computer memory operably connected to the at least one processor and storing instructions that, when executed, cause the at least one processor to perform operations.

In another aspect of the present disclosure, provided herein is a processing device in a wireless communication system. The processing device includes: at least one processor; and at least one computer memory operably connected to the at least one processor and storing instructions that, when executed, cause the at least one processor to perform operations.

In another aspect of the present disclosure, provided herein is a computer-readable storage medium. The computer-readable storage medium is configured to store at least one program code including instructions that, when executed, cause at least one processor to perform operations.

The method or operations include: determining a bit sequence of size N by encoding an information block of size K based on a polar code of size N; selecting k bit positions from among N bit positions in the bit sequence based on a predetermined puncturing pattern; selecting k intermediate bit values from among intermediate bit values generated during the encoding of the information block based on the polar code of size N, based on a predetermined extension pattern; and generating a codeword of size N by replacing bit values at the k bit positions in the bit sequence with the k intermediate bit values.

In each aspect of the present disclosure, the information block may be a transport block (TB) with a TB cyclic redundancy check (CRC) attached, which is obtained by adding the TB CRC to the TB, or a code block (CB) with a TB CRC attached, which is obtained by adding the CB CRC to the CB.

In each aspect of the present disclosure, the method or operations include: performing rate matching on the codeword based on a radio resource allocated for transmission of the codeword and a target code rate; and transmitting the rate-matched codeword on the radio resource.

In each aspect of the present disclosure, the predetermined puncturing pattern may be one of a plurality of different puncturing patterns predetermined for a plurality of polar codes with at least different values of K or N, and the plurality of different puncturing patterns may be predetermined such that a shorter puncturing pattern is a subset of a longer puncturing pattern.

In each aspect of the present disclosure, the predetermined extension pattern may be one of a plurality of different extension patterns predetermined for a plurality of polar codes with at least different values of K or N, and the plurality of different extension patterns may be predetermined such that a shorter extension pattern is a subset of a longer extension pattern.

In another aspect of the present disclosure, provided herein is a method of decoding an encoded information block in a wireless communication system.

In another aspect of the present disclosure, provided herein is a communication device configured to decode an encoded information block in a wireless communication system. The communication device includes: at least one transceiver; at least one processor; and at least one computer memory operably connected to the at least one processor and storing instructions that, when executed, cause the at least one processor to perform operations.

The method or operations include: receiving an encoded information block; and determining an information block of size K by decoding the encoded information block based on a polar code of size N, a predetermined puncturing pattern, and a predetermined extension pattern.

In each aspect of the present disclosure, the predetermined puncturing pattern may be used to select k bit positions from among N bit positions in a bit sequence of size N, which is generated based on the polar code of size N and the information block of size K. The predetermined extension pattern may be used to select k intermediate bit values from among intermediate bit values generated during the encoding of the information block of size N into the bit sequence. The encoded information block may be obtained from a codeword generated by replacing bit values at the k bit positions in the bit sequence with the k intermediate bit values.

In each aspect of the present disclosure, the encoded information block may be a rate-matched codeword.

The foregoing solutions are merely a part of the examples of the present disclosure and various examples into which the technical features of the present disclosure are incorporated may be derived and understood by persons skilled in the art from the following detailed description.

## Advantageous Effects

According to some implementation(s) of the present disclosure, a wireless communication signal may be efficiently transmitted/received. Accordingly, the total throughput of a wireless communication system may be raised.

The polar code according to some implementations of the present disclosure may achieve superior error correction performance under various conditions compared to the polar codes previously used.

The polar code according to some implementations of the present disclosure may be used as a key technology for ultra-reliable and low latency communications (URLLC) in 6G communication.

The effects according to the present disclosure are not limited to what has been particularly described hereinabove and other effects not described herein will be more clearly understood by persons skilled in the art related to the present disclosure from the following detailed description.

## BRIEF DESCRIPTION OF THE DRAWINGS

The accompanying drawings, which are included to provide a further understanding of the present disclosure, illustrate examples of implementations of the present disclosure and together with the detailed description serve to explain implementations of the present disclosure:

FIG. 1 illustrates an example of a communication system 1 to which implementations of the present disclosure are applied;

FIG. 2 is a block diagram illustrating examples of communication devices capable of performing a method according to the present disclosure;

FIG. 3 illustrates another example of a wireless device capable of performing implementation(s) of the present disclosure;

FIG. 4 illustrates an example of a frame structure used in a 3rd generation partnership project (3GPP)-based wireless communication system;

FIG. 5 illustrates a process for processing a transport block (TB) on a transmitting side;

FIG. 6 is an exemplary block diagram for a polar encoder;

FIG. 7 illustrates the concept of channel splitting and channel combining for channel polarization;

FIG. 8 illustrates N-th level channel combining for polar codes;

FIG. 9 illustrates evolution of decoding paths in a list-L decoding process;

FIG. 10 is a diagram to explain the concept of selecting position(s) to which information bit(s) are to be allocated in polar codes;

FIG. 11 illustrates puncturing and information bit allocation for polar codes;

FIG. 12 illustrates a method of generating parity check bit(s) used in polar codes;

FIG. 13 is a diagram to explain a rate matching process according to some implementations of the present disclosure;

FIG. 14 illustrates a process of determining polar codes according to some implementations of the present disclosure;

FIG. 15 is a diagram for explaining a puncturing pattern design and an extension pattern design according to some implementations of the present disclosure;

FIG. 16 illustrates extension candidate bits available for extension in some implementations of the present disclosure;

FIGS. 17 and 18 are diagrams for explaining a process of selecting extension bits at each layer in a polar code butterfly network;

FIG. 19 illustrates the word error rate (WER) performance of a polar code according to some implementations of the present disclosure;

FIG. 20 is a diagram for explaining the concept of a nested puncturing pattern and an extension pattern;

FIG. 21 is a diagram for explaining a method of determining integrated extension pattern(s) according to some implementations of the present disclosure;

FIG. 22 illustrates the WER performance of a code designed/determined according to some implementations of the present disclosure, a fifth generation (5G) New Radio (NR) standard polar code, and a Reed-Muller (RM) code when successive cancellation list (SCL) decoding is used;

FIG. 23 illustrates a channel encoding process according to some implementations of the present disclosure; and

FIG. 24 illustrates a channel decoding process according to some implementations of the present disclosure.

## DETAILED DESCRIPTION

Hereinafter, implementations according to the present disclosure will be described in detail with reference to the accompanying drawings. The detailed description, which will be given below with reference to the accompanying drawings, is intended to explain exemplary implementations of the present disclosure, rather than to show the only implementations that may be implemented according to the present disclosure. The following detailed description includes specific details in order to provide a thorough understanding of the present disclosure. However, it will be apparent to those skilled in the art that the present disclosure may be practiced without such specific details.

In some instances, known structures and devices may be omitted or may be shown in block diagram form, focusing on important features of the structures and devices, so as not to obscure the concept of the present disclosure. The same reference numbers will be used throughout the present disclosure to refer to the same or like parts.

A technique, a device, and a system described below may be applied to a variety of wireless multiple access systems. The multiple access systems may include, for example, a code division multiple access (CDMA) system, a frequency division multiple access (FDMA) system, a time division multiple access (TDMA) system, an orthogonal frequency division multiple access (OFDMA) system, a single-carrier frequency division multiple access (SC-FDMA) system, a multi-carrier frequency division multiple access (MC-FDMA) system, etc. CDMA may be implemented by radio technology such as universal terrestrial radio access (UTRA) or CDMA2000. TDMA may be implemented by radio technology such as global system for mobile communications (GSM), general packet radio service (GPRS), enhanced data rates for GSM evolution (EDGE) (i.e., GERAN), etc. OFDMA may be implemented by radio technology such as institute of electrical and electronics engineers (IEEE) 802.11 (Wi-Fi), IEEE 802.16 (WiMAX), IEEE 802.20, evolved-UTRA (E-UTRA), etc. UTRA is part of universal mobile telecommunications system (UMTS) and 3rd generation partnership project (3GPP) long-term evolution (LTE) is part of E-UMTS using E-UTRA. 3GPP LTE adopts OFDMA on downlink (DL) and adopts SC-FDMA on uplink (UL). LTE-advanced (LTE-A) is an evolved version of 3GPP LTE.

For convenience of description, description will be given under the assumption that the present disclosure is applied to LTE and/or new RAT (NR). However, the technical features of the present disclosure are not limited thereto. For example, although the following detailed description is given based on mobile communication systems corresponding to 3GPP LTE/NR systems, the mobile communication systems are applicable to other arbitrary mobile communication systems except for matters that are specific to the 3GPP LTE/NR system.

For terms and techniques that are not described in detail among terms and techniques used in the present disclosure, reference may be made to 3GPP based standard specifications, for example, 3GPP TS 36.211, 3GPP TS 36.212, 3GPP TS 36.213, 3GPP TS 36.321, 3GPP TS 36.300, 3GPP TS 36.331, 3GPP TS 37.213, 3GPP TS 38.211, 3GPP TS 38.212, 3GPP TS 38.213, 3GPP TS 38.214, 3GPP TS 38.300, 3GPP TS 38.331, etc.

In examples of the present disclosure described later, if a device "assumes" something, this may mean that a channel transmission entity transmits a channel in compliance with the corresponding "assumption." This also may mean that a channel reception entity receives or decodes the channel in the form of conforming to the "assumption" on the premise that the channel has been transmitted in compliance with the "assumption."

In the present disclosure, a user equipment (UE) may be fixed or mobile. Each of various devices that transmit and/or receive user data and/or control information by communicating with a base station (BS) may be the UE. The term UE may be referred to as terminal equipment, mobile station (MS), mobile terminal (MT), user terminal (UT), subscriber station (SS), wireless device, personal digital assistant (PDA), wireless modem, handheld device, etc. In the present disclosure, a BS refers to a fixed station that communicates with a UE and/or another BS and exchanges data and control information with a UE and another BS. The term BS may be referred to as advanced base station (ABS), Node-B (NB), evolved Node-B (eNB), base transceiver system (BTS), access point (AP), processing server (PS), etc. Particularly, a BS of a universal terrestrial radio access (UTRAN) is referred to as an NB, a BS of an evolved-UTRAN (E-UTRAN) is referred to as an eNB, and a BS of new radio access technology network is referred to as a gNB. Hereinbelow, for convenience of description, the NB, eNB, or gNB will be referred to as a BS regardless of the type or version of communication technology.

In the present disclosure, a node refers to a fixed point capable of transmitting/receiving a radio signal to/from a UE by communication with the UE. Various types of BSs may be used as nodes regardless of the names thereof. For example, a BS, NB, eNB, pico-cell eNB (PeNB), home eNB (HeNB), relay, repeater, etc. may be a node. Furthermore, a node may not be a BS. For example, a radio remote head (RRH) or a radio remote unit (RRU) may be a node. Generally, the RRH and RRU have power levels lower than that of the BS. Since the RRH or RRU (hereinafter, RRH/RRU) is connected to the BS through a dedicated line such as an optical cable in general, cooperative communication according to the RRH/RRU and the BS may be smoothly performed relative to cooperative communication according to BSs connected through a wireless link. At least one antenna is installed per node. An antenna may refer to a physical antenna port or refer to a virtual antenna or an antenna group. The node may also be called a point.

In the present disclosure, a cell refers to a specific geographical area in which one or more nodes provide communication services. Accordingly, in the present disclosure, communication with a specific cell may mean communication with a BS or a node providing communication services to the specific cell. A DL/UL signal of the specific cell refers to a DL/UL signal from/to the BS or the node providing communication services to the specific cell. A cell providing UL/DL communication services to a UE is especially called a serving cell. Furthermore, channel status/quality of the specific cell refers to channel status/quality of a channel or a communication link generated between the BS or the node providing communication services to the specific cell and the UE. In 3GPP-based communication systems, the UE may measure a DL channel state from a specific node using cell-specific reference signal(s) (CRS(s)) transmitted on a CRS resource and/or channel state information reference signal(s) (CSI-RS(s)) transmitted on a CSI-RS resource, allocated to the specific node by antenna port(s) of the specific node.

A 3GPP-based communication system uses the concept of a cell in order to manage radio resources, and a cell related with the radio resources is distinguished from a cell of a geographic area.

The "cell" of the geographic area may be understood as coverage within which a node may provide services using a carrier, and the "cell" of the radio resources is associated with bandwidth (BW), which is a frequency range configured by the carrier. Since DL coverage, which is a range within which the node is capable of transmitting a valid signal, and UL coverage, which is a range within which the node is capable of receiving the valid signal from the UE, depend upon a carrier carrying the signal, coverage of the node may also be associated with coverage of the "cell" of radio resources used by the node. Accordingly, the term "cell" may be used to indicate service coverage by the node sometimes, radio resources at other times, or a range that a signal using the radio resources may reach with valid strength at other times.

In 3GPP communication standards, the concept of the cell is used in order to manage radio resources. The "cell" associated with the radio resources is defined by a combination of DL resources and UL resources, that is, a combination of a DL component carrier (CC) and a UL CC. The cell may be configured by the DL resources only or by the combination of the DL resources and the UL resources. If carrier aggregation is supported, linkage between a carrier frequency of the DL resources (or DL CC) and a carrier frequency of the UL resources (or UL CC) may be indicated by system information. For example, the combination of the DL resources and the UL resources may be indicated by system information block type 2 (SIB2) linkage. In this case, the carrier frequency may be equal to or different from a center frequency of each cell or CC. When carrier aggregation (CA) is configured, the UE has only one radio resource control (RRC) connection with a network. During RRC connection establishment/re-establishment/handover, one serving cell provides non-access stratum (NAS) mobility information. During RRC connection re-establishment/handover, one serving cell provides security input. This cell is referred to as a primary cell (Pcell). The Pcell refers to a cell operating on a primary frequency on which the UE performs an initial connection establishment procedure or initiates a connection re-establishment procedure. According to UE capability, secondary cells (Scells) may be configured to form a set of serving cells together with the Pcell. The Scell may be configured after completion of RRC connection establishment and used to provide additional radio resources in addition to resources of a specific cell (SpCell). A carrier corresponding to the Pcell on DL is referred to as a downlink primary CC (DL PCC), and a carrier corresponding to the Pcell on UL is referred to as an uplink primary CC (UL PCC). A carrier corresponding to the Scell on DL is referred to as a downlink secondary CC (DL SCC), and a carrier corresponding to the Scell on UL is referred to as an uplink secondary CC (UL SCC).

In a wireless communication system, the UE receives information on DL from the BS and the UE transmits information on UL to the BS. The information that the BS and UE transmit and/or receive includes data and a variety of control information and there are various physical channels according to types/usage of the information that the UE and the BS transmit and/or receive.

The 3GPP-based communication standards define DL physical channels corresponding to resource elements carrying information originating from a higher layer and DL physical signals corresponding to resource elements which are used by the physical layer but do not carry the information originating from the higher layer. For example, a physical downlink shared channel (PDSCH), a physical broadcast channel (PBCH), a physical multicast channel (PMCH), a physical control format indicator channel (PCFICH), a physical downlink control channel (PDCCH), etc. are defined as the DL physical channels, and a reference signal (RS) and a synchronization signal (SS) are defined as the DL physical signals. The RS, which is also referred to as a pilot, represents a signal with a predefined special waveform known to both the BS and the UE. For example, a demodulation reference signal (DMRS), a channel state information RS (CSI-RS), etc. are defined as DL RSs. The 3GPP-based communication standards define UL physical channels corresponding to resource elements carrying information originating from the higher layer and UL physical signals corresponding to resource elements which are used by the physical layer but do not carry the information originating from the higher layer. For example, a physical uplink shared channel (PUSCH), a physical uplink control channel (PUCCH), and a physical random access channel (PRACH) are defined as the UL physical channels, and a DMRS for a UL control/data signal, a sounding reference signal (SRS) used for UL channel measurement, etc. are defined.

In the present disclosure, a PDCCH refers to a set of time-frequency resources (e.g., resource elements (REs)) carrying downlink control information (DCI), and a PDSCH refers to a set of time-frequency resources carrying DL data. A PUCCH, a PUSCH, and a PRACH refer to a set of time-frequency resources carrying UCI, a set of time-frequency resources carrying UL data, and a set of time-frequency resources carrying random access signals, respectively. In the following description, "the UE transmits/receives a PUCCH/PUSCH/PRACH" is used as the same meaning that the UE transmits/receives the UCI/UL data/random access signals on or through the PUCCH/PUSCH/PRACH, respectively. In addition, "the BS transmits/receives a PBCH/PDCCH/PDSCH" is used as the same meaning that the BS transmits the broadcast information/DCI/DL data on or through a PBCH/PDCCH/PDSCH, respectively.

In the present disclosure, a radio resource (e.g., a time-frequency resource) scheduled or configured to the UE by the BS for transmission or reception of the PUCCH/PUSCH/PDSCH may be referred to as a PUCCH/PUSCH/PDSCH resource.

Since a communication device receives a synchronization signal block (SSB), DMRS, CSI-RS, PBCH, PDCCH, PDSCH, PUSCH, and/or PUCCH in the form of radio signals on a cell, the communication device may not select and receive radio signals including only a specific physical channel or a specific physical signal through a radio frequency (RF) receiver, or may not select and receive radio signals without a specific physical channel or a specific physical signal through the RF receiver. In actual operations, the communication device receives radio signals on the cell via the RF receiver, converts the radio signals, which are RF band signals, into baseband signals, and then decodes physical signals and/or physical channels in the baseband signals using one or more processors. Thus, in some implementations of the present disclosure, reception of physical signals and/or physical channels may mean that a communication device does not attempt to restore the physical signals and/or physical channels from radio signals, for example, does not attempt to decode the physical signals and/or physical channels, rather than that the communication device does not actually receive the radio signals including the corresponding physical signals and/or physical channels.

As more and more communication devices have required greater communication capacity, there has been a need for eMBB communication relative to legacy radio access technology (RAT). In addition, massive MTC for providing various services at anytime and anywhere by connecting a plurality of devices and objects to each other is one main issue to be considered in next-generation communication. Further, communication system design considering services/UEs sensitive to reliability and latency is also under discussion. The introduction of next-generation RAT is being discussed in consideration of eMBB communication, massive MTC, ultra-reliable and low-latency communication (URLLC), and the like. Currently, in 3GPP, a study on the next-generation mobile communication systems after EPC is being conducted. In the present disclosure, for convenience, the corresponding technology is referred to as a new RAT (NR) or fifth-generation (5G) RAT, and a system using NR or supporting NR is referred to as an NR system.

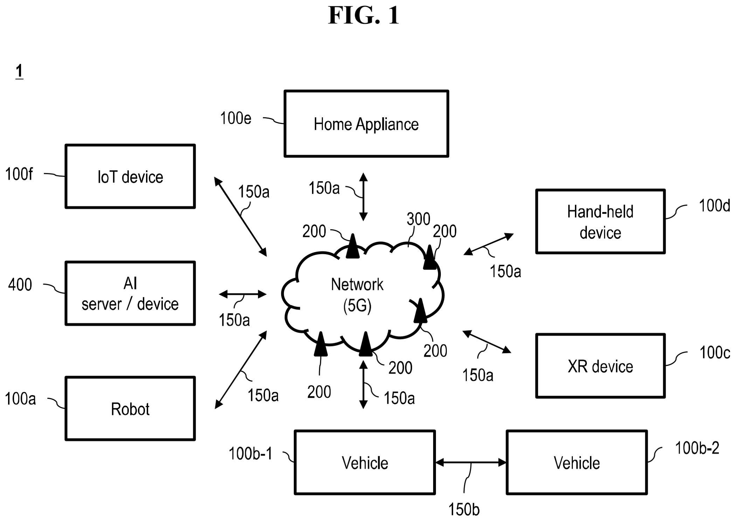

FIG. 1 illustrates an example of a communication system 1 to which implementations of the present disclosure are applied. Referring to FIG. 1, the communication system 1 applied to the present disclosure includes wireless devices, BSs, and a network. Here, the wireless devices represent devices performing communication using RAT (e.g., 5G NR or LTE (e.g., E-UTRA)) and may be referred to as communication/radio/SG devices. The wireless devices may include, without being limited to, a robot 100a, vehicles 100b-1 and 100b-2, an extended reality (XR) device 100c, a hand-held device 100d, a home appliance 100e, an Internet of Things (IoT) device 100f, and an artificial intelligence (AI) device/server 400. For example, the vehicles may include a vehicle having a wireless communication function, an autonomous driving vehicle, and a vehicle capable of performing vehicle-to-vehicle communication. Here, the vehicles may include an unmanned aerial vehicle (UAV) (e.g., a drone). The XR device may include an augmented reality (AR)/virtual reality (VR)/mixed reality (MR) device and may be implemented in the form of a head-mounted device (HMD), a head-up display (HUD) mounted in a vehicle, a television, a smartphone, a computer, a wearable device, a home appliance device, a digital signage, a vehicle, a robot, etc. The hand-held device may include a smartphone, a smartpad, a wearable device (e.g., a smartwatch or smartglasses), and a computer (e.g., a notebook). The home appliance may include a TV, a refrigerator, and a washing machine. The IoT device may include a sensor and a smartmeter. For example, the BSs and the network may also be implemented as wireless devices and a specific wireless device may operate as a BS/network node with respect to another wireless device.

The wireless devices 100a to 100f may be connected to a network 300 via BSs 200. AI technology may be applied to the wireless devices 100a to 100f and the wireless devices 100a to 100f may be connected to the AI server 400 via the network 300. The network 300 may be configured using a 3G network, a 4G (e.g., LTE) network, or a 5G (e.g., NR) network. Although the wireless devices 100a to 100f may communicate with each other through the BSs 200/network 300, the wireless devices 100a to 100f may perform direct communication (e.g., sidelink communication) with each other without passing through the BSs/network. For example, the vehicles 100b-1 and 100b-2 may perform direct communication (e.g., vehicle-to-vehicle (V2V)/Vehicle-to-everything (V2X) communication). The IoT device (e.g., a sensor) may perform direct communication with other IoT devices (e.g., sensors) or other wireless devices 100a to 100f.

Wireless communication/connections 150a and 150b may be established between the wireless devices 100a to 100f and the BSs 200 and between the wireless devices 100a to 100f). Here, the wireless communication/connections such as UL/DL communication 150a and sidelink communication 150b (or, device-to-device (D2D) communication) may be established by various RATs (e.g., 5G NR). The wireless devices and the BSs/wireless devices may transmit/receive radio signals to/from each other through the wireless communication/connections 150a and 150b. To this end, at least a part of various configuration information configuring processes, various signal processing processes (e.g., channel encoding/decoding, modulation/demodulation, and resource mapping/demapping), and resource allocating processes, for transmitting/receiving radio signals, may be performed based on the various proposals of the present disclosure.

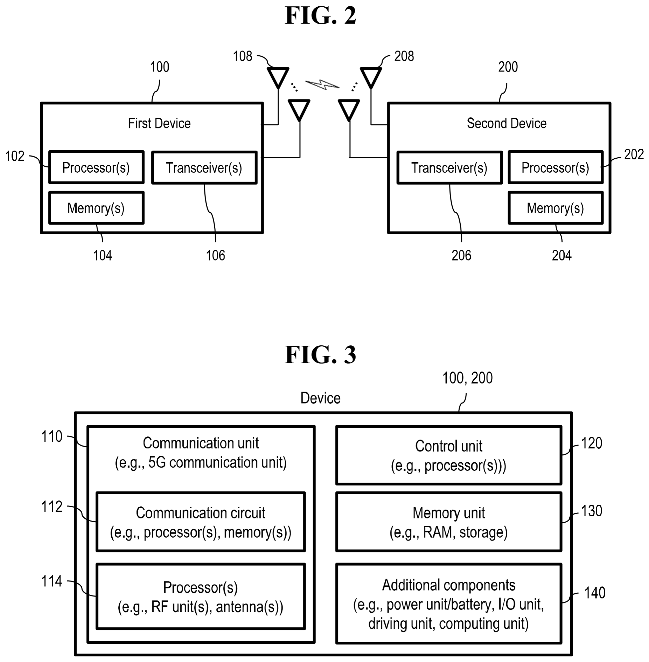

FIG. 2 is a block diagram illustrating examples of communication devices capable of performing a method according to the present disclosure. Referring to FIG. 2, a first wireless device 100 and a second wireless device 200 may transmit and/or receive radio signals through a variety of RATs (e.g., LTE and NR). Here, {the first wireless device 100 and the second wireless device 200} may correspond to {the wireless device 100x and the BS 200} and/or {the wireless device 100x and the wireless device 100x} of FIG. 1.

The first wireless device 100 may include one or more processors 102 and one or more memories 104 and additionally further include one or more transceivers 106 and/or one or more antennas 108. The processor(s) 102 may control the memory(s) 104 and/or the transceiver(s) 106 and may be configured to implement the below-described /proposed functions, procedures, and/or methods. For example, the processor(s) 102 may process information within the memory(s) 104 to generate first information/signals and then transmit radio signals including the first information/signals through the transceiver(s) 106. The processor(s) 102 may receive radio signals including second information/signals through the transceiver(s) 106 and then store information obtained by processing the second information/signals in the memory(s) 104. The memory(s) 104 may be connected to the processor(s) 102 and may store a variety of information related to operations of the processor(s) 102. For example, the memory(s) 104 may perform a part or all of processes controlled by the processor(s) 102 or store software code including instructions for performing the below-described/-proposed procedures and/or methods. Here, the processor(s) 102 and the memory(s) 104 may be a part of a communication modem/circuit/chip designed to implement RAT (e.g., LTE or NR). The transceiver(s) 106 may be connected to the processor(s) 102 and transmit and/or receive radio signals through one or more antennas 108. Each of the transceiver(s) 106 may include a transmitter and/or a receiver. The transceiver(s) 106 is used interchangeably with radio frequency (RF) unit(s). In the present disclosure, the wireless device may represent the communication modem/circuit/chip.

The second wireless device 200 may include one or more processors 202 and one or more memories 204 and additionally further include one or more transceivers 206 and/or one or more antennas 208. The processor(s) 202 may control the memory(s) 204 and/or the transceiver(s) 206 and may be configured to implement the below-described/proposed functions, procedures, and/or methods. For example, the processor(s) 202 may process information within the memory(s) 204 to generate third information/signals and then transmit radio signals including the third information/signals through the transceiver(s) 206. The processor(s) 202 may receive radio signals including fourth information/signals through the transceiver(s) 106 and then store information obtained by processing the fourth information/signals in the memory(s) 204. The memory(s) 204 may be connected to the processor(s) 202 and may store a variety of information related to operations of the processor(s) 202. For example, the memory(s) 204 may perform a part or all of processes controlled by the processor(s) 202 or store software code including instructions for performing the below-described/-proposed procedures and/or methods. Here, the processor(s) 202 and the memory(s) 204 may be a part of a communication modem/circuit/chip designed to implement RAT (e.g., LTE or NR). The transceiver(s) 206 may be connected to the processor(s) 202 and transmit and/or receive radio signals through one or more antennas 208. Each of the transceiver(s) 206 may include a transmitter and/or a receiver. The transceiver(s) 206 is used interchangeably with RF unit(s). In the present disclosure, the wireless device may represent the communication modem/circuit/chip.

The wireless communication technology implemented in the wireless devices 100 and 200 of the present disclosure may include narrowband Internet of things for low-power communication as well as LTE, NR, and 6G. For example, the NB-IoT technology may be an example of low-power wide-area network (LPWAN) technologies and implemented in standards such as LTE Cat NB1 and/or LTE Cat NB2. However, the NB-IoT technology is not limited to the above names. Additionally or alternatively, the wireless communication technology implemented in the wireless devices XXX and YYY of the present disclosure may perform communication based on the LTE-M technology. For example, the LTE-M technology may be an example of LPWAN technologies and called by various names including enhanced machine type communication (eMTC). For example, the LTE-M technology may be implemented in at least one of the following various standards: 1) LTE CAT 0, 2) LTE Cat M1, 3) LTE Cat M2, 4) LTE non-Bandwidth Limited (non-BL), 5) LTE-MTC, 6) LTE Machine Type Communication, and/or 7) LTE M, etc., but the LTE-M technology is not limited to the above names. Additionally or alternatively, the wireless communication technology implemented in the wireless devices XXX and YYY of the present disclosure may include at least one of ZigBee, Bluetooth, and LPWAN in consideration of low-power communication, but the wireless communication technology is not limited to the above names. For example, the ZigBee technology may create a personal area network (PAN) related to small/low-power digital communication based on various standards such as IEEE 802.15.4 and so on, and the ZigBee technology may be called by various names.

Hereinafter, hardware elements of the wireless devices 100 and 200 will be described more specifically. One or more protocol layers may be implemented by, without being limited to, one or more processors 102 and 202. For example, the one or more processors 102 and 202 may implement one or more layers (e.g., functional layers such as a physical (PHY) layer, medium access control (MAC) layer, a radio link control (RLC) layer, a packet data convergence protocol (PDCP) layer, radio resource control (RRC) layer, and a service data adaptation protocol (SDAP) layer). The one or more processors 102 and 202 may generate one or more protocol data units (PDUs) and/or one or more service data units (SDUs) according to the functions, procedures, proposals, and/or methods disclosed in the present disclosure. The one or more processors 102 and 202 may generate messages, control information, data, or information according to the functions, procedures, proposals, and/or methods disclosed in the present disclosure. The one or more processors 102 and 202 may generate signals (e.g., baseband signals) including PDUs, SDUs, messages, control information, data, or information according to the functions, procedures, proposals, and/or methods disclosed in the present disclosure and provide the generated signals to the one or more transceivers 106 and 206. The one or more processors 102 and 202 may receive the signals (e.g., baseband signals) from the one or more transceivers 106 and 206 and acquire the PDUs, SDUs, messages, control information, data, or information according to the functions, procedures, proposals, and/or methods disclosed in the present disclosure.

The one or more processors 102 and 202 may be referred to as controllers, microcontrollers, microprocessors, or microcomputers. The one or more processors 102 and 202 may be implemented by hardware, firmware, software, or a combination thereof. As an example, one or more application specific integrated circuits (ASICs), one or more digital signal processors (DSPs), one or more digital signal processing devices (DSPDs), one or more programmable logic devices (PLDs), or one or more field programmable gate arrays (FPGAs) may be included in the one or more processors 102 and 202. The functions, procedures, proposals, and/or methods disclosed in the present disclosure may be implemented using firmware or software, and the firmware or software may be configured to include the modules, procedures, or functions. Firmware or software configured to perform the functions, procedures, proposals, and/or methods disclosed in the present disclosure may be included in the one or more processors 102 and 202 or stored in the one or more memories 104 and 204 so as to be driven by the one or more processors 102 and 202. The functions, procedures, proposals, and/or methods disclosed in the present disclosure may be implemented using firmware or software in the form of code, commands, and/or a set of commands.

The one or more memories 104 and 204 may be connected to the one or more processors 102 and 202 and store various types of data, signals, messages, information, programs, code, commands, and/or instructions. The one or more memories 104 and 204 may be configured by read-only memories (ROMs), random access memories (RAMs), electrically erasable programmable read-only memories (EPROMs), flash memories, hard drives, registers, cash memories, computer-readable storage media, and/or combinations thereof. The one or more memories 104 and 204 may be located at the interior and/or exterior of the one or more processors 102 and 202. The one or more memories 104 and 204 may be connected to the one or more processors 102 and 202 through various technologies such as wired or wireless connection.

The one or more transceivers 106 and 206 may transmit user data, control information, and/or radio signals/channels, mentioned in the methods and/or operational flowcharts of the present disclosure, to one or more other devices. The one or more transceivers 106 and 206 may receive user data, control information, and/or radio signals/channels, mentioned in the functions, procedures, proposals, methods, and/or operational flowcharts disclosed in the present disclosure, from one or more other devices. For example, the one or more transceivers 106 and 206 may be connected to the one or more processors 102 and 202 and transmit and receive radio signals. For example, the one or more processors 102 and 202 may perform control so that the one or more transceivers 106 and 206 may transmit user data, control information, or radio signals to one or more other devices. The one or more processors 102 and 202 may perform control so that the one or more transceivers 106 and 206 may receive user data, control information, or radio signals from one or more other devices. The one or more transceivers 106 and 206 may be connected to the one or more antennas 108 and 208. The one or more transceivers 106 and 206 may be configured to transmit and receive user data, control information, and/or radio signals/channels, mentioned in the functions, procedures, proposals, methods, and/or operational flowcharts disclosed in the present disclosure, through the one or more antennas 108 and 208. In the present disclosure, the one or more antennas may be a plurality of physical antennas or a plurality of logical antennas (e.g., antenna ports). The one or more transceivers 106 and 206 may convert received radio signals/channels etc. from RF band signals into baseband signals in order to process received user data, control information, radio signals/channels, etc. using the one or more processors 102 and 202. The one or more transceivers 106 and 206 may convert the user data, control information, radio signals/channels, etc. processed using the one or more processors 102 and 202 from the base band signals into the RF band signals. To this end, the one or more transceivers 106 and 206 may include (analog) oscillators and/or filters.

FIG. 3 illustrates another example of a wireless device capable of performing implementation(s) of the present disclosure. Referring to FIG. 3, wireless devices 100 and 200 may correspond to the wireless devices 100 and 200 of FIG. 2 and may be configured by various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the communication circuit 112 may include the one or more processors 102 and 202 and/or the one or more memories 104 and 204 of FIG. 2. For example, the transceiver(s) 114 may include the one or more transceivers 106 and 206 and/or the one or more antennas 108 and 208 of FIG. 2. The control unit 120 is electrically connected to the communication unit 110, the memory 130, and the additional components 140 and controls overall operation of the wireless devices. For example, the control unit 120 may control an electric/mechanical operation of the wireless device based on programs/code/commands/information stored in the memory unit 130. The control unit 120 may transmit the information stored in the memory unit 130 to the exterior (e.g., other communication devices) via the communication unit 110 through a wireless/wired interface or store, in the memory unit 130, information received through the wireless/wired interface from the exterior (e.g., other communication devices) via the communication unit 110.

The additional components 140 may be variously configured according to types of wireless devices. For example, the additional components 140 may include at least one of a power unit/battery, input/output (I/O) unit, a driving unit, and a computing unit. The wireless device may be implemented in the form of, without being limited to, the robot (100a of FIG. 1), the vehicles (100b-1 and 100b-2 of FIG. 1), the XR device (100c of FIG. 1), the hand-held device (100d of FIG. 1), the home appliance (100e of FIG. 1), the IoT device (100f of FIG. 1), a digital broadcast UE, a hologram device, a public safety device, an MTC device, a medicine device, a fintech device (or a finance device), a security device, a climate/environment device, the AI server/device (400 of FIG. 1), the BS (200 of FIG. 1), a network node, etc. The wireless device may be used in a mobile or fixed place according to a use-case/service.

In FIG. 3, the entirety of the various elements, components, units/portions, and/or modules in the wireless devices 100 and 200 may be connected to each other through a wired interface or at least a part thereof may be wirelessly connected through the communication unit 110. For example, in each of the wireless devices 100 and 200, the control unit 120 and the communication unit 110 may be connected by wire and the control unit 120 and first units (e.g., 130 and 140) may be wirelessly connected through the communication unit 110. Each element, component, unit/portion, and/or module within the wireless devices 100 and 200 may further include one or more elements. For example, the control unit 120 may be configured by a set of one or more processors. As an example, the control unit 120 may be configured by a set of a communication control processor, an application processor, an electronic control unit (ECU), a graphical processing unit, and a memory control processor. As another example, the memory 130 may be configured by a random access memory (RAM), a dynamic RAM (DRAM), a read-only memory (ROM)), a flash memory, a volatile memory, a non-volatile memory, and/or a combination thereof.

In the present disclosure, the at least one memory (e.g., 104 or 204) may store instructions or programs, and the instructions or programs may cause, when executed, at least one processor operably connected to the at least one memory to perform operations according to some embodiments or implementations of the present disclosure.

In the present disclosure, a computer readable (non-volatile) storage medium may store at least one instruction or program, and the at least one instruction or program may cause, when executed by at least one processor, the at least one processor to perform operations according to some embodiments or implementations of the present disclosure.

In the present disclosure, a processing device or apparatus may include at least one processor, and at least one computer memory operably connected to the at least one processor. The at least one computer memory may store instructions or programs, and the instructions or programs may cause, when executed, the at least one processor operably connected to the at least one memory to perform operations according to some embodiments or implementations of the present disclosure.

In the present disclosure, a computer program may include program code stored on at least one computer-readable (non-volatile) storage medium and, when executed, configured to perform operations according to some implementations of the present disclosure or cause at least one processor to perform the operations according to some implementations of the present disclosure. The computer program may be provided in the form of a computer program product. The computer program product may include at least one computer-readable (non-volatile) storage medium.

A communication device of the present disclosure includes at least one processor; and at least one computer memory operably connected to the at least one processor and configured to store instructions for causing, when executed, the at least one processor to perform operations according to example(s) of the present disclosure described later.

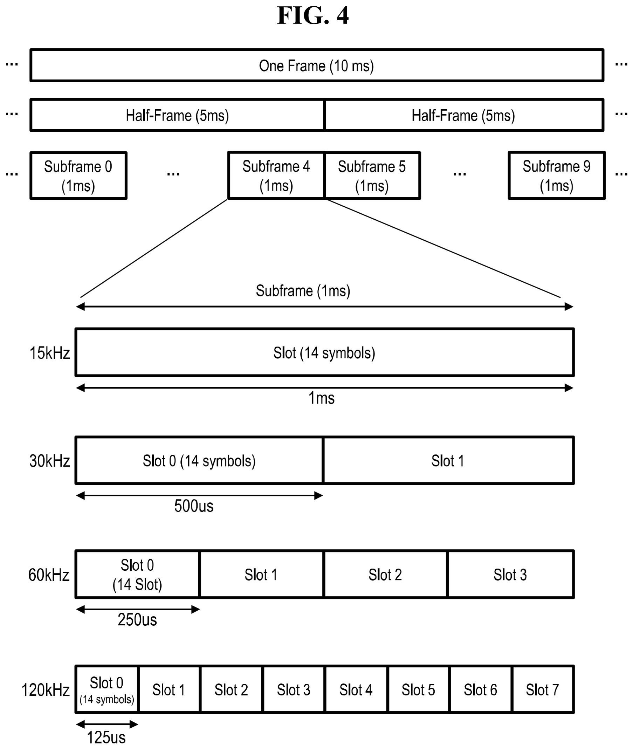

FIG. 4 illustrates an example of a frame structure used in a 3GPP-based wireless communication system.

The frame structure of FIG. 4 is purely exemplary and the number of subframes, the number of slots, and the number of symbols, in a frame, may be variously changed. In an NR system, different OFDM numerologies (e.g., subcarrier spacings (SCSs)) may be configured for multiple cells which are aggregated for one UE. Accordingly, the (absolute time) duration of a time resource including the same number of symbols (e.g., a subframe, a slot, or a transmission time interval (TTI)) may be differently configured for the aggregated cells. Here, the symbol may include an OFDM symbol (or cyclic prefix - OFDM (CP-OFDM) symbol) and an SC-FDMA symbol (or discrete Fourier transform-spread-OFDM (DFT-s-OFDM) symbol). In the present disclosure, the symbol, the OFDM-based symbol, the OFDM symbol, the CP-OFDM symbol, and the DFT-s-OFDM symbol are used interchangeably.

Referring to FIG. 4, in the NR system, UL and DL transmissions are organized into frames. Each frame has a duration of $T_f = (\triangle f_{max}*N_f/100)*T_c = 10$ ms and is divided into two half-frames of 5 ms each. A basic time unit for NR is $T_c = 1/(\triangle f_{max}*N_f)$ where $\triangle f_{max} = 480*10^3$ Hz and $N_f = 4096$. For reference, a basic time unit for LTE is $T_s = 1/(\triangle f_{ref}*N_{f,ref})$ where $\triangle f_{ref} = 15*10^3$ Hz and $N_{f,ref} = 2048$. $T_c$ and $T_f$ have the relationship of a constant $\kappa = T_c/T_f = 64$. Each half-frame includes 5 subframes and a duration $T_{sf}$ of a single subframe is 1 ms. Subframes are further divided into slots and the number of slots in a subframe depends on a subcarrier spacing. Each slot includes 14 or 12 OFDM symbols based on a cyclic prefix. In a normal CP, each slot includes 14 OFDM symbols and, in an extended CP, each slot includes 12 OFDM symbols. The numerology depends on an exponentially scalable subcarrier spacing $\Delta f = 2^u*15$ kHz. The table below shows the number of OFDM symbols ($N^{slot}_{symb}$) per slot, the number of slots ($N^{frame,u}_{slot}$) per frame, and the number of slots ($N^{subframe,u}_{slot}$) per subframe.

Table 1

| $u$ | $N^{slot}_{symb}$ | $N^{frame,u}_{slot}$ | $N^{subframe,u}_{slot}$ |
|---|---|---|---|
| 0 | 14 | 10 | 1 |
| 1 | 14 | 20 | 2 |
| 2 | 14 | 40 | 4 |
| 3 | 14 | 80 | 8 |
| 4 | 14 | 160 | 16 |

The table below shows the number of OFDM symbols per slot, the number of slots per frame, and the number of slots per subframe, according to the subcarrier spacing $\triangle f = 2^u*15$ kHz.

Table 2

| $u$ | $N^{slot}_{symb}$ | $N^{frame,u}_{slot}$ | $N^{subframe,u}_{slot}$ |
|---|---|---|---|
| 2 | 12 | 40 | 4 |

For a subcarrier spacing configuration u, slots may be indexed within a subframe in ascending order as follows: $n^u_s \in \{0, ..., n^{subframe,u}_{slot} - 1\}$ and indexed within a frame in ascending order as follows: $n^u_{s,f} \in \{0, ..., n^{frame,u}_{slot} - 1\}$.

The slot includes multiple (e.g., 14 or 12) symbols in the time domain. For each numerology (e.g., subcarrier spacing) and carrier, a resource grid of $N^{size,u}_{grid,x} * N^{RB}_{sc}$ subcarriers and $N^{subframe,u}_{symb}$ OFDM symbols is defined, starting at a common resource block (CRB) $N^{start,u}_{grid}$ indicated by higher layer signaling (e.g., RRC signaling), where $N^{size,u}_{grid,x}$ is the number of resource blocks (RBs) in the resource grid and the subscript x is DL for downlink and UL for uplink. $N^{RB}_{sc}$ is the number of subcarriers per RB. In the 3GPP-based wireless communication system, $N^{RB}_{sc}$ is typically 12. There is one resource grid for a given antenna port $p$, a subcarrier spacing configuration $u$, and a transmission link (DL or UL). The carrier bandwidth $N^{size,u}_{grid}$ for the subcarrier spacing configuration $u$ is given to the UE by a higher layer parameter (e.g., RRC parameter). Each element in the resource grid for the antenna port $p$ and the subcarrier spacing configuration $u$ is referred to as a resource element (RE) and one complex symbol may be mapped to each RE. Each RE in the resource grid is uniquely identified by an index k in the frequency domain and an index $l$ representing a symbol location relative to a reference point in the time domain. In the NR system, an RB is defined by 12 consecutive subcarriers in the frequency domain. In the NR system, RBs are classified into CRBs and physical resource blocks (PRBs). The CRBs are numbered from 0 upwards in the frequency domain for the subcarrier spacing configuration $u$. The center of subcarrier 0 of CRB 0 for the subcarrier spacing configuration $u$ is equal to 'Point A' which serves as a common reference point for RB grids. The PRBs for subcarrier spacing configuration $u$ are defined within a bandwidth part (BWP) and numbered from 0 to $N^{size,u}_{BWP,i}-1$, where i is a number of the BWP. The relation between a PRB $n_{PRB}$ in a BWP i and a CRB $n^u_{CRB}$ is given by: $n^u_{PRB} = n^u_{CRB} + N^{size,u}_{BWP,i}$, where $N^{size}_{BWP,i}$ is a CRB in which the BWP starts relative to CRB 0. The BWP includes a plurality of consecutive RBs in the frequency domain. For example, the BWP may be a subset of contiguous CRBs defined for a given numerology $u_i$ in the BWP i on a given carrier. A carrier may include a maximum of N (e.g., 5) BWPs. The UE may be configured to have one or more BWPs on a given component carrier. Data communication is performed through an activated BWP and only a predetermined number of BWPs (e.g., one BWP) among BWPs configured for the UE may be active on the component carrier.

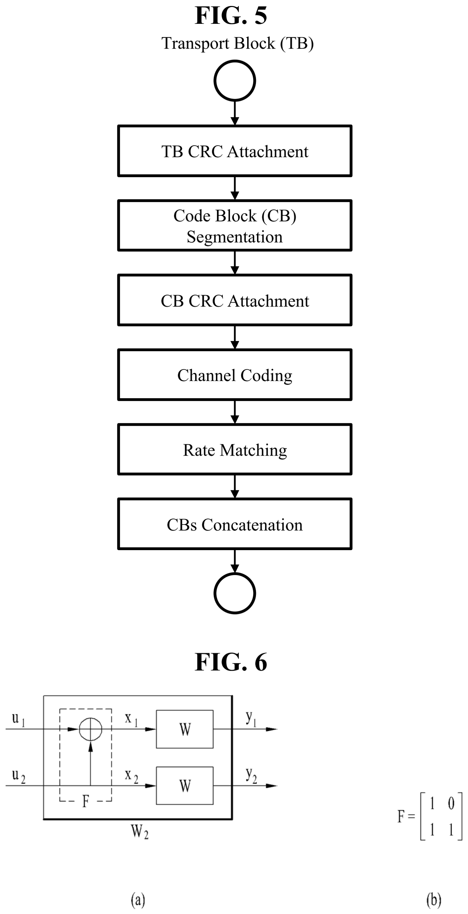

FIG. 5 illustrates a process for processing a transport block (TB) on a transmitting side.

In order for a receiving side to correct errors that radio signals experience in a radio channel, a transmitting side encodes information using a forward error correction code and then transmits the encoded information. The receiving side demodulates a received signal and decodes the error correction code to thereby recover the information transmitted by the transmitting side. In this decoding procedure, errors in the received signal caused by a radio channel are corrected.

Data arrives at a coding block in the form of a maximum of two transport blocks every transmission time interval (TTI) in each DL/UL cell. The following coding steps may be applied to each transport block of the DL/UL cell:

- cyclic redundancy check (CRC) attachment to a transport block;
- code block segmentation and CRC attachment to a code block;
- channel coding;
- rate matching; and
- code block concatenation.

In an actual communication system, a transport block of a predetermined size or larger is divided into a plurality of smaller data blocks and then is encoded, to facilitate actual implementation of coding. The smaller data blocks are called code blocks. While the code blocks are generally of the same size, one of the code blocks may have a different size due to a limited size of an internal interleaver of a channel encoder. Error correction coding is performed on each code block of a predetermined interleaver size and then interleaving is performed to reduce the impact of burst errors that are generated during transmission over a radio channel. The error-corrected and interleaved code block is transmitted by being mapped to an actual radio resource. The amount of radio resources used for actual transmission is designated. Thus, the encoded code blocks are rate-matched to the amount of the radio resources. In general, rate matching is performed through puncturing or repetition. For example, if the amount of radio resources, i.e., the number of transmission bits capable of being transmitted on the radio resources, is M and if a coded bit sequence, i.e., the number of output bits of the encoder, is N, in which M is different from N, then rate matching is performed to match the length of the coded bit sequence to M. If M>N, then all or a part of bits of the coded bit sequence are repeated to match the length of the rate-matched sequence to M. If M<N, then a part of the bits of the coded bit sequence is punctured to match the length of the rate-matched sequence to M and the punctured bits are excluded from transmission.

In wireless communication systems, the transmitting side encodes data to be transmitted based on channel coding with a specific code rate. Then, the transmitting side adjusts the code rate of the data to be transmitted through a rate matching process involving puncturing and repetition.

There are various types of error correction codes, but the size of an information block capable of achieving optimal performance is determined depending on the error correction code. While many coding schemes are available for achieving high-capacity information performance with long information block lengths, the majority of the coding schemes do not consistently show good performance over a wide range of information block lengths and code rates. However, turbo codes, low-density parity check (LPDC) codes, and polar codes show promising BLER performance in a wide range of coding rates and code lengths and hence are considered to be used in the NR system. As demand for various cases such as eMBB, massive IoT, and URLLC has increased, a coding scheme providing greater channel coding efficiency than in turbo codes is needed. In addition, increase in a maximum number of subscribers capable of being accommodated by a channel, i.e., increase in capacity, has been required. Polar codes among various error correction codes are codes providing a new framework capable of solving problems of legacy channel codes and were invented by Arikan at Bilkent University (reference: E. Arikan, "Channel Polarization: A Method for Constructing Capacity-Achieving Codes for Symmetric Binary-Input Memoryless Channels," in IEEE Transactions on Information Theory, vol. 55, no. 7, pp. 3051-3073, July 2009). Polar codes are the first capacity-achieving codes with low encoding and decoding complexities, which were proven mathematically. Polar codes outperform the turbo codes in large information block lengths while no error flow is present. Hereinafter, channel coding using the polar codes is referred to as polar coding.

Polar codes are known as codes capable of achieving the capacity of a given binary discrete memoryless channel. This can be achieved only when a block size is sufficiently large. That is, polar codes are codes capable of achieving the capacity of a channel if the size N of the codes infinitely increases. Polar codes have low encoding and decoding complexity and may be successfully decoded. Polar codes are a sort of linear block error correction codes. Multiple recursive concatenations are basic building blocks for the polar codes and are bases for code construction. Physical conversion of channels in which physical channels are converted into virtual channels occurs and such conversion is based on a plurality of recursive concatenations. If multiple channels are multiplied and accumulated, most of the channels may become better or worse. The idea underlying polar codes is to use good channels. For example, data is sent through good channels at rate 1 and data is sent through bad channels at rate 0. That is, through channel polarization, channels enter a polarized state from a normal state.

FIG. 6 is an example of a block diagram for a polar encoder.

FIG. 6(a) illustrates a base module of a polar code, particularly, first level channel combining for polar coding. In FIG. 6(a), $W_2$ denotes an entire equivalent channel obtained by combining two binary-input discrete memoryless channels (B-DMCs), Ws. Herein, $u_1$ and $u_2$ are binary-input source bits and $y_1$ and $y_2$ are output coded bits. Channel combining is a procedure of concatenating the B-DMCs in parallel.

FIG. 6(b) illustrates a base matrix F for the base module. The binary-input source bits $u_1$ and $u_2$ input to the base matrix F and the output coded bits $x_1$ and $x_2$ of the base matrix F have the following relationship.

$$\text{Equation 1}$$

$$[\,u_1 \ u_2\,]\begin{bmatrix} 1 & 0 \\ 1 & 1 \end{bmatrix} = [\,x_1 \ x_2\,]$$

The channel $W_2$ may achieve symmetric capacity I(W) which is a highest rate. In the B-DMC W, symmetric capacity is an important parameter which is used to measure a rate and is a highest rate at which reliable communication can occur over the channel W. The B-DMC may be defined as follows.

$$\text{Equation 2}$$

$$I(W) = \sum_{y \in Y} \sum_{x \in X} \frac{1}{2} W(y|x) \log \frac{w(y|x)}{\frac{1}{2} w(y|0) + \frac{1}{2} w(y|1)}$$

It is possible to synthesize or create a second set of N binary input channels out of N independent copies of a given B-DMC W and the channels have the properties $\{W_N^{(i)}: 1<=i<=N\}$. If N increases, there is a tendency for a part of the channels to have capacity approximating to 1 and for the remaining channels to have capacity approximating to 0. This is called channel polarization. In other words, channel polarization is a process of creating a second set of N channels $\{W_N^{(i)}: 1<=i<=N\}$ using N independent copies of a given B-DMC W. The effect of channel polarization means that, when N increases, all symmetric capacity terms $\{I(W_N^{(i)})\}$ tend towards 0 or 1 for all except a vanishing fraction of indexes i. In other words, the concept behind channel polarization in the polar codes is transforming N copies (i.e., N transmissions) of a channel having a symmetric capacity of I(W) (e.g., additive white Gaussian noise channel) into extreme channels of capacity close to 1 or 0. Among the N channels, an I(W) fraction will be perfect channels and an 1-I(W) fraction will be completely noise channels. Then, information bits are transmitted only through good channels and bits input to the other channels are frozen to 1 or 0. The amount of channel polarization increases along with a block length. Channel polarization consists of two phases: channel combining phase and channel splitting phase.

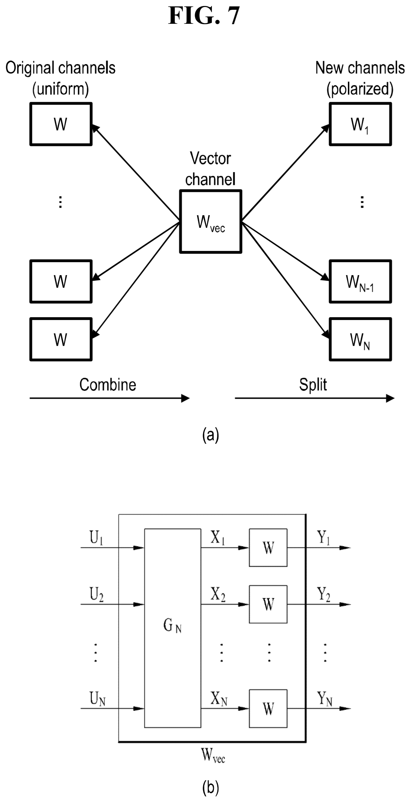

FIG. 7 illustrates the concept of channel combining and channel splitting for channel polarization. As illustrated in FIG. 7, when N copies of an original channel W are properly combined to create a vector channel $W_{vec}$ and then are split into new polarized channels, the new polarized channels are categorized into channels having capacity C(W)=1 and channels having C(W)=0 if N is sufficiently large. In this case, since bits passing through the channels having the channel capacity C(W))=1 are transmitted without error, it is better to transmit information bits therethrough and, since bits passing through the channels having capacity C(W)=0 cannot transport information, it is better to transport frozen bits, which are meaningless bits, therethrough.

Referring to FIG. 7(a), copies of a given B-DMC W are combined in a recursive manner to output a vector channel $W_{vec}$ given by $X_N \to Y_N$, where N=2" and n is an integer equal to or greater than 0. Recursion always begins at the 0th level and $W_1$ = W. If n is 1 (n=1), this means the first level of recursion in which two independent copies of $W_1$ are combined. If the above two copies are combined, a channel $W_2: X_2 \to Y_2$ is obtained. A transitional probability of this new channel $W_2$ may be represented by the following equation.

Equation 3

$$W_2(y_1, y_2 | u_1, u_2) = W(y_1 | u_1 \oplus u_2) W(y_1 | u_2)$$

If the channel $W_2$ is obtained, two copies of the channel $W_2$ are combined to obtain a single copy of a channel $W_4$. Such recursion may be represented by $W_4: X_4 \to Y_4$ having the following transitional probability.

Equation 4

$$W_4(y_1^4 | u_1^4) = W_2(y_1^2 | u_1 \oplus u_2, u_3 \oplus u_4) W_2(y_3^4 | u_2, u_4)$$

In FIG. 7(b), $G_N$ is a size-N generator matrix. The relationship between input $u^N_1$ to $G_N$ and output $x^N_1$ of $G_N$ of FIG. 7(b) may be represented as $x^N_1 = u^N_1 G_N$, where $x^N_1 = \{x_1, ..., x_N\}$, $u^N_1 = \{u_1, ..., u_N\}$. When N B-DMCs are combined, each B-DMC may be expressed in a recursive manner. That is, $G_N$ may be indicated by the following equation.

Equation 5

$$G_N = B_N F^{\mathbf{W}n}$$

Herein, $\otimes$ denotes the Kronecker product, $N=2^n$, $n>=1$, $F^{\otimes n} = F \otimes F^{\otimes(n-1)}$, and $F^{\otimes 0} = 1$. $B_N$ is a permutation matrix known as a bit-reversal operation and $B_N = R_N(I_2 \otimes B_{N/2})$ and may be recursively computed. $I_2$ is a 2-dimensional identity matrix and this recursion is initialized to $B_2 = I_2$. $R_N$ is a bit-reversal interleaver and is used to map an input $\mathbf{s}^N_1 = \{s_1, ..., s_N\}$ to an output $x^N_1 = \{s_1, s_3, ..., s_{N-1}, s_2, ..., s_N\}$. For example, $\mathbf{G}_2$ corresponds to a base matrix $\mathbf{F}$ shown in FIG. 6(b). $\mathbf{G}_4$ may be expressed as the following matrix.

Equation 6

$$G_4 = \begin{bmatrix} 1 & 0 & 0 & 0 \\ 0 & 0 & 1 & 0 \\ 0 & 1 & 0 & 0 \\ 0 & 0 & 0 & 1 \end{bmatrix} \begin{bmatrix} 1 & 0 \\ 1 & 1 \end{bmatrix}^{\otimes 2} = \begin{bmatrix} 1 & 0 & 0 & 0 \\ 1 & 0 & 1 & 0 \\ 1 & 1 & 0 & 0 \\ 1 & 1 & 1 & 1 \end{bmatrix}$$

A bit-reversal interleaver may not be included on the transmitting side. Without considering the bit-reversal interleaver, $\mathbf{G}_N$ may be expressed as $\mathbf{G}_N = (\mathbf{G}_2)^{\otimes n}$ (where $N=2^n$). $(\mathbf{G}_2)^{\otimes n}$ denotes the n-th Kronecker power of the matrix $\mathbf{G}_2$, where $\mathbf{G}_2$ is the same as the basic matrix F shown in FIG. 6(b).

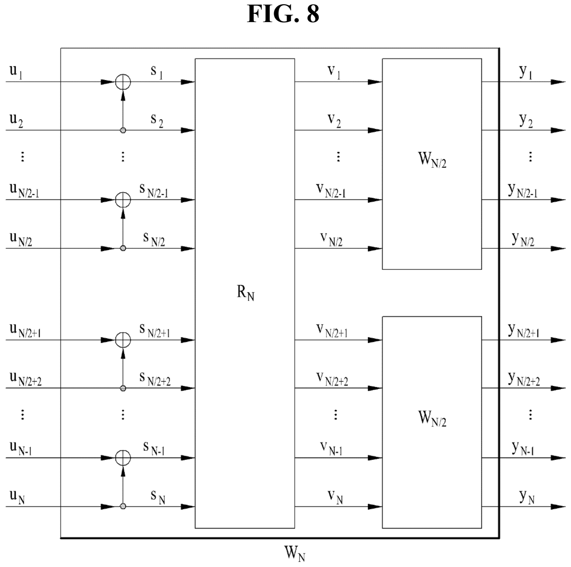

The relationship of Equation 5 is illustrated in FIG. 8.

FIG. 8 illustrates N-th level channel combining for a polar code.

A process of defining an equivalent channel for specific input after combining N B-DMCs Ws is called channel splitting. Channel splitting may be represented as a channel transition probability indicated by the following equation.

Equation 7

$$W_N^i(y_1^N, u_1^{i-1}|u_i) = \sum_{u_{i+1}^N} \frac{1}{2^{N-1}} W_N(y_1^N|u_1^N)$$

Channel polarization has the following characteristics:

> Conservation: C(W⁻) + C(W⁺) = 2C(W),
> Extremization: C(W⁻) <= C(W) <= C(W⁺).

When channel combining and channel splitting are performed, the following theorem may be obtained.

* Theorem: For any B-DMC W, channels {$W_N^{(i)}$} are polarized in the following sense. For any fixed $\delta \in \{0,1\}$, as N goes to infinity through powers of 2, the fraction of indexes $i \in \{1,...,N\}$ for channel capacity $I(W_N^{(i)}) \in (1-\delta,1]$ goes to I(W) and the faction of i for channel capacity $I(W_N^{(i)}) \in [0,\delta)$ goes to 1-I(W). Hence, if N→∞, then channels are perfectly noisy or are polarized free of noise. These channels can be accurately recognized by the transmitting side. Therefore, bad channels are fixed and non-fixed bits may be transmitted on good channels.

That is, if the size N of polar codes is infinite, a channel has much noise or is free of noise, with respect to a specific input bit. This has the same meaning that the capacity of an equivalent channel for a specific input bit is divided into 0 or I(W).

Inputs of a polar encoder are divided into bit channels to which information data is mapped and bit channels to which the information data is not mapped. As described earlier, according to the theorem of the polar code, if a codeword of the polar code goes to infinity, the input bit channels may be classified into noiseless channels and noise channels. Therefore, if information is allocated to the noiseless bit channels, channel capacity may be obtained. However, in actuality, a codeword of an infinite length cannot be configured, reliabilities of the input bit channels are calculated and data bits are allocated to the input bit channels in order of reliabilities. In the present disclosure, bit channels to which data bits are allocated are referred to as good bit channels. The good bit channels may be input bit channels to which the data bits are mapped. Bit channels to which data is not mapped are referred to as frozen bit channels. A known value (e.g., 0) is input to the frozen bit channels and then encoding is performed. Any values which are known to the transmitting side and the receiving side may be mapped to the frozen bit channels. When puncturing or repetition is performed, information about the good bit channels may be used. For example, positions of codeword bits (i.e., output bits) corresponding to positions of input bits to which information bits are not allocated may be punctured.

A decoding scheme of the polar codes is a successive cancellation (SC) decoding scheme. The SC decoding scheme obtains a channel transition probability and then calculates a log-likelihood ratio (LLR) of input bits using the channel transition probability. In this case, the channel transition probability may be calculated in a recursive form if channel combining and channel splitting procedures use characteristics of the recursive form. Therefore, a final LLR value may also be calculated in the recursive form. First, a channel transition probability $W_N^{(i)}(y_1^N, u_1^{i-1}|u_1)$ of an input bit $u_i$ may be obtained as follows. $u_1^i$ may be split into odd indexes and even indexes as expressed as $u_{1,o}^i$, $u_{1,e}^i$, respectively. The channel transition probability may be indicated by the following equations.

Equation 8

$$W_{2N}^{(2i-1)}(y_1^{2N}, u_1^{2i-1}|u_{2i-1})$$

$$= \sum_{u_{2i}^{2N}} \frac{1}{2^{2N-1}} W_{2N}(y_1^{2N}|u_1^{2N})$$

$$= \sum_{u_{2i,o}^{2N}, u_{2i,e}^{2N}} \frac{1}{2^{2N-1}} W_N(y_1^N|u_{1,o}^{2N} \oplus u_{i,e}^{2N}) W_N(y_{N+1}^{2N}|u_{1,e}^{2N})$$

$$= \sum_{u_{2i}} \frac{1}{2} \sum_{u_{2i+1,e}^{2N}} \frac{1}{2^{N-1}} W_N(y_{N+1}^{2N}|u_{1,e}^{2N}) \cdot \sum_{u_{2i+1,o}^{2N}} \frac{1}{2^{N-1}} W_N(y_1^N|u_{1,o}^{2N} \oplus u_{i,e}^{2N})$$

$$= \sum_{u_{2i}} \frac{1}{2} W_N^{(i)}(y_1^N, u_{1,o}^{2i-2} \oplus u_{i,e}^{2i-2}|u_{2i-1} \oplus u_{2i}) \cdot W_N^{(i)}(y_{N+1}^{2N}, u_{1,e}^{2i-2}|u_{2i})$$

$$where \ W_N^{(i)}(y_1^N, u_1^{i-1}|u_i) = \sum_{u_{i+1}^N} \frac{1}{2^{N-1}} W_N(y_1^N|u_1^N).$$

Equation 9

$$W_{2N}^{(2i)}(y_1^{2N}, u_1^{2i-1} | u_{2i})$$

$$= \sum_{u_{2i+1}^{2N}} \frac{1}{2^{2N-1}} W_{2N}(y_1^{2N} | u_1^{2N})$$

$$= \sum_{u_{2i+1,o}^{2N}, u_{2i+1,e}^{2N}} \frac{1}{2^{2N-1}} W_N(y_1^N | u_{1,o}^{2N} \oplus u_{i,e}^{2N}) W_N(y_{N+1}^{2N} | u_{1,e}^{2N})$$

$$= \frac{1}{2} \sum_{u_{2i+1,e}^{2N}} \frac{1}{2^{N-1}} W_N(y_{N+1}^{2N} | u_{1,e}^{2N}) \cdot \sum_{u_{2i+1,o}^{2N}} \frac{1}{2^{N-1}} W_N(y_1^N | u_{1,o}^{2N} \oplus u_{i,e}^{2N})$$

$$= \frac{1}{2} W_N^{(i)}(y_1^N, u_{1,o}^{2i-2} \oplus u_{i,e}^{2i-2} | u_{2i-1} \oplus u_{2i}) \cdot W_N^{(i)}(y_{N+1}^{2N}, u_{1,e}^{2i-2} | u_{2i})$$

A polar decoder retrieves information and generates an estimate $u^{\wedge N}{}_1$ of $u^N{}_1$ using values (e.g., reception bits, frozen bits, etc.) known for the polar codes. The LLR is defined as follows.

Equation 10

$$L_N^{(i)}(y_1^N, u_1^{i-1}) = \frac{W_N^{(i)}(y_1^N, u_1^{i-1} | u_i = 0)}{W_N^{(i)}(y_1^N, u_1^{i-1} | u_i = 1)}$$

The LLR may be recursively calculated as follows.

Equation 11

$$L_N^{(2i-1)}(y_1^N, \hat{u}_1^{2i-2}) = \frac{L_{N/2}^{(i)}(y_1^{N/2}, \hat{u}_{1,o}^{2i-2} \oplus \hat{u}_{1,e}^{2i-2}) \cdot L_{N/2}^{(i)}(y_{N/2+1}^N, \hat{u}_{1,e}^{2i-2}) + 1}{L_{N/2}^{(i)}(y_1^{N/2}, \hat{u}_{1,o}^{2i-2} \oplus \hat{u}_{1,e}^{2i-2}) + L_{N/2}^{(i)}(y_{N/2+1}^N, \hat{u}_{1,e}^{2i-2})}$$

$$L_N^{(2i)}(y_1^N, \hat{u}_1^{2i-1}) = [L_{N/2}^{(i)}(y_1^{N/2}, \hat{u}_{1,o}^{2i-2} \oplus \hat{u}_{1,e}^{2i-2})]^{1-2\hat{u}_{2i-1}} \cdot L_{N/2}^{(i)}(y_{N/2+1}^N, \hat{u}_{1,e}^{2i-2})$$

Recursive calculation of LLRs is traced back to a code length of 1 with an LLR $L^{(1)}{}_1(y_i) = W(y_i|0)/W(y_i|1)$. $L^{(1)}{}_1(y_i)$ is soft information observed from a channel.

The complexity of a polar encoder and an SC decoder varies with the length N of polar codes and is known as having $O(N\log N)$. Assuming that K input bits are used for a length-N polar code, a coding rate becomes N/K. If a generator matrix of a polar encoder of a data payload size N is $G_N$, an encoded bit may be represented as $x^N{}_1 = u^N{}_1 G_N$. It is assumed that K bits out of $u^N{}_1$ correspond to payload bits, a row index of $G_N$ corresponding to the payload bits is i, and a row index of $G_N$ corresponding to (N-K) bits is F. A minimum distance of the polar codes may be given as $d_{min}(C) = min_{i \in I} 2^{wt(i)})$, where wt(i) is the number of 1s within binary extension of i and i=0,1,...,N-1.

SC list (SCL) decoding is an extension of a basic SC decoder. In this type of decoder, L decoding paths are simultaneously considered in each decoding stage. Herein, L is an integer. In other words, in the case of the polar codes, a list-L decoding algorithm is an algorithm for simultaneously tracking L paths in a decoding process.

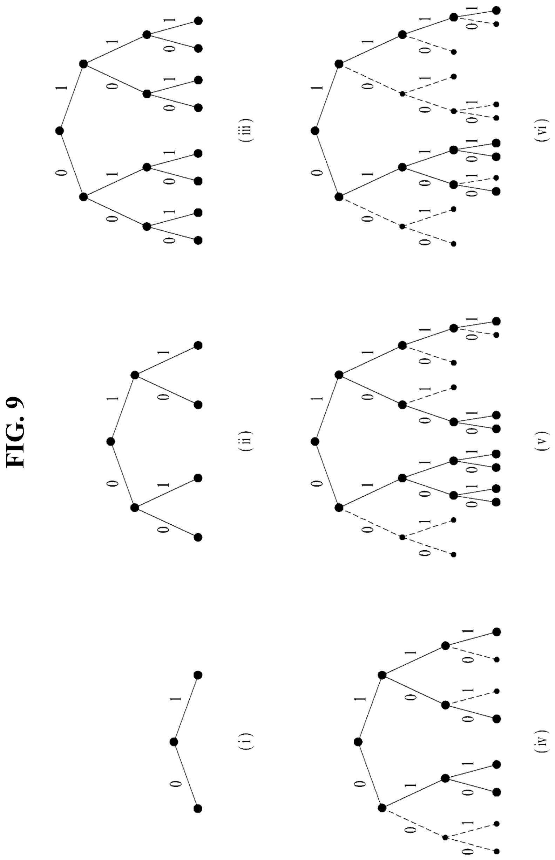

FIG. 9 illustrates an evolution of decoding paths in a list-L decoding process. For convenience of description, it is assumed that the number of bits that should be determined is n and all bits are not frozen. If a list size L is 4, each level includes at most 4 nodes with paths that continue downward. Discontinued paths are expressed by dotted lines in FIG. 9. A process in which decoding paths evolve in list-L decoding will now be described with reference to FIG. 9. i) If list-L decoding is started, the first unfrozen bit may be either 0 or 1. ii) list-L decoding continues. The second unfrozen bits may be either 0 or 1. Since the number of paths is not greater than L=4, pruning is not needed yet. iii) Consideration of all options for the first bit (i.e., a bit of the first level), the second bit (i.e., a bit of the second level), and the third bit (i.e., a bit of the third level) results in 8 decoding paths which are excessive because L=4. iv) the 8 decoding paths are pruned to L (=4) promising paths. v) 4 active paths continue by considering two options of the fourth unfrozen bit. In this case, the number of paths is doubled, i.e., 8 paths which are excessive because L=4. vi) The 8 paths are pruned back to L (=4) best paths. In the example of FIG. 7, 4 candidate codewords 0100, 0110, 0111, and 1111 are obtained and one of the codewords is determined to be a codeword most similar to an original codeword. In a similar manner to a normal decoding process, for example, in a pruning process or a process of determining a final codeword, a path in which the sum of LLR absolute values is largest may be selected as a survival path. If a CRC is present, the survival path may be selected through the CRC.

Meanwhile, CRC-aided SCL decoding is SCL decoding using CRC and improves the performance of polar codes. CRC is the most widely used technique in error detection and error correction in the field of information theory and coding. For example, if an input block of an error correction encoder has K bits and the length of information bits is k, and the length of CRC sequences is m bits, then K = k + m. CRC bits are a part of source bits for an error correction code. If the size of channel codes used for encoding is N, a code rate R is defined as R=K/N. CRC aided SCL decoding serves to detect an errorless path while a receiving device confirms a CRC code with respect to each path. An SCL decoder outputs candidate sequences to a CRC detector. The CRC detector feeds back a check result in order to aid in determining a codeword.

Although complicated as compared with an SC algorithm, SCL decoding or CRC aided SCL decoding has an advantage of excellent decoding performance. For more details of a list-L decoding algorithm of the polar codes, refer to 'I. Tal and A. Vardy, "List decoding of polar codes," in Proc. IEEE Int. Symp. Inf. Theory, pp. 1-5, Jul. 2011'.

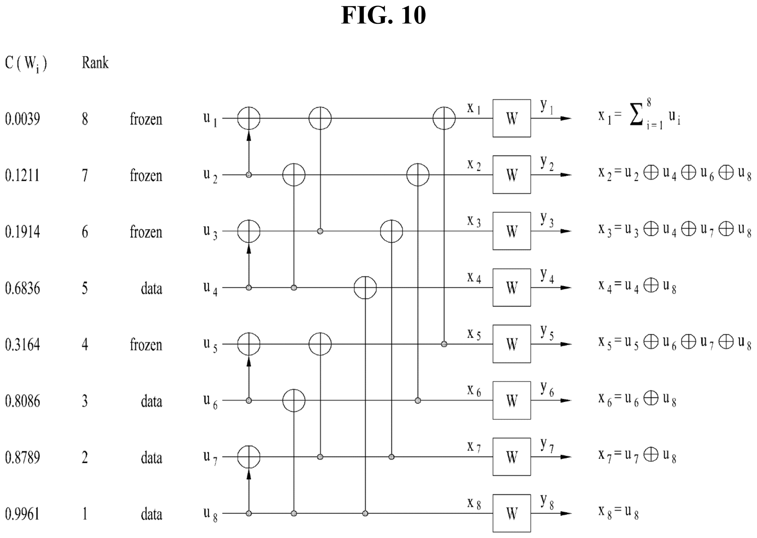

FIG. 10 illustrates the concept of selecting position(s) to which information bit(s) are to be allocated in polar codes.

In the example of FIG. 10, it is assumed that the size N of mother codes is 8, i.e., the size N of polar codes is 8, and a code rate is 1/2.

In FIG. 10, $C(W_i)$ denotes the capacity of a channel $W_i$ and corresponds to the reliability of channels that input bits of a polar code experience. When channel capacities corresponding to input bit positions of the polar code are as illustrated in FIG. 10, reliabilities of the input bit positions are ranked as illustrated in FIG. 10. To transmit data at a code rate of 1/2, a transmitting device allocates 4 bits constituting the data to 4 input bit positions having high channel capacities among 8 input bit positions (i.e., input bit positions denoted as $u_4$, $u_6$, $u_7$, and us among input bit positions $u_1$ to us of FIG. 10) and freezes the other input bit positions. A generator matrix $G_8$ corresponding to the polar code of FIG. 10 is as follows. The generator matrix $G_8$ may be acquired based on $(G_2)^{\otimes n}$.

$$\text{Equation 12}$$

$$G_8 = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

The input bit positions denoted as $u_1$ to $u_8$ of FIG. 10 correspond one by one to rows from the highest row to the lowest row of $G_8$. Referring to FIG. 10, it may be appreciated that the input bit corresponding to $u_8$ affects all output coded bits. On the other hand, it may be appreciated that the input bit corresponding to $u_1$ affects only $y_1$ among the output coded bits. Referring to Equation 12, when binary-input source bits $u_1$ to $u_8$ are multiplied by $G_8$, a row in which the input bits appear at all output bits is the lowest row [1, 1, 1, 1, 1, 1, 1, 1] in which all elements are 1, among rows of $G_8$. Meanwhile, a row in which the binary-input source bits appears at only one output bit is a row in which one element is 1 among the rows of $G_8$, i.e., a row [1, 0, 0, 0, 0, 0, 0, 0] in which a row weight is 1. Similarly, it may be appreciated that a row in which a row weight is 2 reflects input bits corresponding to the row in two output bits. Referring to FIG. 10 and Equation 12, $u_1$ to $u_8$ correspond one by one to the rows of $G_8$ and bit indexes for distinguishing between input positions of $u_1$ to $u_8$, i.e., bit indexes for distinguishing between the input positions, may be assigned to the rows of $G_8$.

Hereinafter, for Polar codes, it may be assumed that bit indexes from 0 to N-1 are sequentially allocated to rows of $G_N$ starting from the highest row having the smallest row weight with respect to N input bits. For example, referring to FIG. 10, a bit index 0 is allocated to the input position of $u_1$, i.e., the first row of $G_8$ and a bit index 7 is allocated to the input position of $u_8$, i.e., the last row of $G_8$. However, since the bit indexes are used to indicate input positions of the polar code, a scheme different from the above allocation scheme may be used. For example, bit indexes from 0 to N-1 may be allocated staring from the lowest row having the largest row weight.

In the case of output bit indexes, as illustrated in FIG. 10 and Equation 12, it may be assumed that bit indexes from 0 to N-1 or bit indexes from 1 to N are assigned to columns from the first column having the largest column weight to the last column having the smallest column weight among columns of $G_N$.

In Polar codes, setting of information bits and frozen bits is one of the most important elements in the configuration and performance of the polar code. That is, determination of ranks of input bit positions may be an important element in the performance and configuration of the polar code. For Polar codes, bit indexes may distinguish input or output positions of the polar code. In the present disclosure, a sequence obtained by enumerating reliabilities of bit positions in ascending or descending order are referred to as a bit index sequence or polar sequence. That is, the bit index sequence represents reliabilities of input or output bit positions of the polar code in ascending or descending order. A transmitting device inputs information bits to input bits having high reliabilities based on the input bit index sequence and performs encoding using the polar code. A receiving device may discern input positions to which information bits are allocated or input positions to which frozen bits are allocated, using the same or corresponding input bit index sequence. That is, the receiving device may perform polar decoding using an input bit index sequence which is identical to or corresponds to an input bit index sequence used by the transmitting device and using a corresponding polar code. In the following description, it may be assumed that an input bit index sequence is predetermined so that information bit(s) may be allocated to input bit position(s) having high reliabilities. In the present disclosure, the input bit index sequence is also called a Polar sequence.

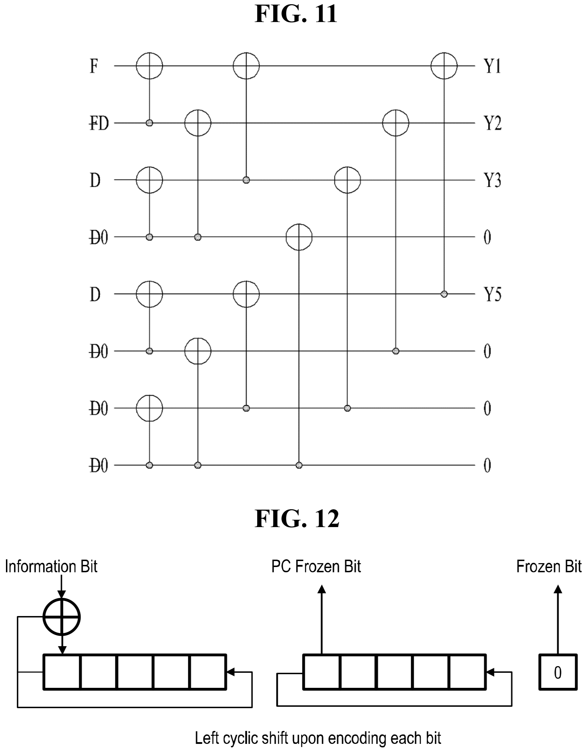

FIG. 11 illustrates puncturing and information bit allocation for polar codes. In FIG. 11, F denotes a frozen bit, D denotes an information bit, and 0 denotes a skipping bit.

Among coded bits, the case in which an information bit is changed to a frozen bit may occur according to an index or position of a punctured bit. For example, if output coded bits for a mother code of N=8 should be punctured in order of Y8, Y7, Y6, Y4, Y5, Y3, Y2, and Y1 and a target code rate is 1/2, then Y8, Y7, Y6, and Y4 are punctured, U8, U7, U6, and U4 connected only to Y8, Y7, Y6, and Y4 are frozen to 0, and these input bits are not transmitted, as illustrated in FIG. 9. An input bit changed to a frozen bit by puncturing of a coded bit is referred to as a skipping bit or a shortening bit and a corresponding input position is referred to as a skipping position or a shortening position. Shortening is a rate matching method of inserting a known bit into an input bit position connected to a position of an output bit desired to be transmitted while maintaining the size of input information (i.e., the size of information blocks). Shortening is possible starting from input corresponding to a column in which a column weight is 1 in a generator matrix $G_N$ and next shortening may be performed with respect to input corresponding to a column in which a column weight is 1 in a remaining matrix from which a column and row in which a column weight is 1 are removed. To prevent all information bits from being punctured, an information bit that should have been allocated to an information bit position may be reallocated in order of a high reliability within a set of frozen bit positions.

In the case of the polar code, decoding may be generally performed in the following order.

> 1. Bit(s) having low reliabilities are recovered first. Although reliability differs according to the structure of a decoder, since an input index in an encoder (hereinafter, an encoder input bit index or bit index) having a low value usually has a low reliability, decoding is generally performed staring from a low encoder input bit index.
> 2. When there is a known bit for a recovered bit, the known bit is used together with the recovered bit or the process of 1 is omitted and a known bit for a specific input bit position is immediately used, thereby recovering an information bit, which is an unknown bit. The information bit may be a source information bit (e.g., a bit of a transport block) or a CRC bit.

As explained earlier, the process of channel combining and channel splitting results in an equivalent channel being divided into a noisy channel and a noise-free channel. A data payload needs be transmitted over the noise-free channel. In other words, the data payload needs to be transmitted over the noise-free equivalent channel to achieve the desired performance. The noise-free equivalent channel may be determined by computing the value of the equivalent channel, $Z(W) = \sum \sqrt{W(y|0)W(y|1)}$ for each input bit. Z(W) is called the Battacharyya parameter, which may represent a value corresponding to the upper bound of the error probability when a MAP (maximum a posteriori probability) decision for transmission of binary input 0 or 1 is performed. Therefore, the transmitting side may obtain the values of Z(W), select equivalent channel(s) up to the size of the data payload in ascending order (e.g., decreasing order) of the values of Z(W), and use the equivalent channel(s) for transmission of the data payload. For a binary erasure channel (BEC), Z(W) may be obtained through Equation 13.

Equation 13

$$Z(W_N^{(i)}) = Z(W_{(b_1,b_2,...,b_{k-1})}) = \begin{cases} 2Z(W_{(b_1,b_2,...,b_{k-1})}) - Z(W_{(b_1,b_2,...,b_{k-1})})^2, & if \ b_k = 0 \\ Z(W_{(b_1,b_2,...,b_{k-1})})^2, & if \ b_k = 1 \end{cases}$$

For example, when the BEC has a binary probability of 0.5 and a code block size of 8, the values of Z(W) may be calculated according to Equation 11 as follows: Z(W) = {1.00, 0.68, 0.81, 0.12, 0.88, 0.19, 0.32, 0.00} . Thus, when the size of a data payload is 2, the data payload may be transmitted over equivalent channel 8 with Z(W) = 0.00 and equivalent channel 4 with Z(W) = 0.12.

As described above, since a polar encoder has different reliability depending on input positions, the transmitting side may allocate a data block (i.e., an information block before encoding) to bit channel(s) in order of reliability according to the size of the corresponding data block and perform encoding by setting all others to be frozen (e.g., with a value of '0'). For example, if the mother code size of the polar encoder (i.e., the maximum size of a code block that the polar encoder is capable of encoding) is N, and if the size of a data block input to the polar encoder is K, polar encoding is performed by arranging the bits of the data block in order of reliability in K bit channels and setting 0 to N-K bit channel(s).

The following shows the polar sequence used in NR (5G) systems (see the polar sequence defined in 3GPP TS 38.212 Rel-15).

< Polar sequence>

| W | I | W | I | W | I | W | I | W | I | W | I | W | I | W | I |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |

(continued)

| W | I | W | I | W | I | W | I | W | I | W | I | W | I | W | I |
|---|---|---|---|---|---|---|---|---|---|---|---|---|---|---|---|
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 1528 | 195 | 108 | 323 | 448 | 451 | 432 | 579 | 666 | 707 | 367 | 835 | 915 | 963 | 510 |

(continued)

| W | I | W | I | W | I | W | I | W | I | W | I | W | I | W | I |
|---|---|---|---|---|---|---|---|---|---|---|---|---|---|---|---|
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |

(continued)

| W | I | W | I | W | I | W | I | W | I | W | I | W | I | W | I |
|---|---|---|---|---|---|---|---|---|---|---|---|---|---|---|---|
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 1152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

The above table shows a Polar sequence $\mathbf{Q}_0^{Nmax-1}$ and a reliability $W(Q_i^{Nmax})$ of the Polar sequence. In the above table, $W$ denotes $W(Q_i^{Nmax})$ and $I$ denotes $Q_i^{Nmax}$. Namely, the Polar sequence $\mathbf{Q}_0^{Nmax-1} = \{Q_0^{Nmax}, Q_1^{Nmax},..., Q_{Nmax-1}^{Nmax}\}$ is given by the above table, where $0<=Q_i^{Nmax}<=Nmax-1$ denotes a bit index (i.e., bit channel index) before Polar encoding for i=0,1,...,Nmax-1. For 3GPP TS 38.212 Rel-15, Nmax = 1024. The Polar sequence $\mathbf{Q}_0^{Nmax-1}$ is ascending order of reliability $W(Q_0^{Nmax})<W(Q_1^{Nmax})<...<W(Q_{Nmax-1}^{Nmax})$, where $W(Q_i^{Nmax})$ denotes the reliability of bit index $Q_i^{Nmax}$. For example, referring to the above table, a reliability $W(Q_i^{Nmax})=3$ of a bit index $Q_i^{Nmax}=4$ is lower than a reliability $W(Q_i^{Nmax})=7$ of bit index $Qi^{Nmax}=3$. That is, the above table lists, in ascending order of reliability, bit indexes 0 to 1023 which respectively indicate 1024 input positions of a Polar code of Nmax=1024.

For any information block encoded to N bits, a same Polar sequence $\mathbf{Q}_0^{N-1} = \{Q_0^N, Q_1^N, Q_2^N,..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$. For example, when N=8, a Polar sequence $\mathbf{Q}_0^7$ includes elements of $Q_i^{Nmax}<8$ among elements of the Polar sequence $\mathbf{Q}_0^{Nmax-1}$ and the elements of $Q_i^{Nmax}<8$ are ordered in ascending order of reliability $W(0)<W(1)<W(2)<W(4)<W(3)<W(5)<W(6)$.

For example, Table 3 lists input bit positions for an information block of size K (=10) input to a Polar code in a Polar sequence of N=512.

Table 3

| | Polar sequence |
|---|---|
| 1 | 505 |
| 2 | 506 |
| 3 | 479 |
| 4 | 508 |

(continued)

|  | Polar sequence |
|---|---|
| 5 | 495 |
| 6 | 503 |
| 7 | 507 |
| 8 | 509 |
| 9 | 510 |
| 10 | 511 |

Table 3 shows 10 elements for K=10 among elements of the Polar sequence of N=512 in ascending order of reliability. Referring to the above-described table of <Polar sequence>, values of I having 10 reliabilities $W(Q_i^{Nmax})$ among values of I ($=Q_i^{Nmax}$) less than N=512 are {479, 495, 503, 505, 506, 507, 508, 509, 510, 511}. If {479, 495, 503, 505, 506, 507, 508, 509, 510, 511} are arranged in ascending order of reliability $W$, {505, 506, 479, 508, 495, 503, 507, 509, 510, 511}, which is a set of bit indexes for K=10 in the Polar sequence of N=512 shown in Table 3, may be obtained.

If the bit sequence input to channel coding is denoted by $c_0,c_1,c_2,c_3,...,c_{K-1}$, the bits after encoding are denoted by $d_0,d_1,d_2,d_3,...,d_{N-1}$, where K is the number of bits to encode, where N=2" and the value of n is determined by the following table.

Table 4

$$\text{If } E \leq (9/8) \cdot 2^{(\lceil \log_2 E \rceil - 1)} \text{ and } K/E < 9/16$$

$$n_1 = \lceil \log_2 E \rceil - 1;$$

$$\text{else}$$

$$n_1 = \lceil \log_2 E \rceil;$$

$$\text{end if}$$

$$R_{min} = 1/8;$$

$$n_2 = \lceil \log_2 (K/R_{min}) \rceil;$$

$$n = \max\{\min\{n_1, n_2, n_{max}\}, n_{min}\}$$

$$\text{where } n_{min} = 5.$$

In Table 4, $n_{max}$ may be a value predetermined depending on the type of channel or control information and/or the number of information bits input into a channel coding block. For example, $n_{max}$ for a broadcast channel (BCH) may be predetermined as 9, $n_{max}$ for DCI may be predetermined as 9, and $n_{max}$ for UCI may be predetermined as 10.

In Table 4, E denotes a rate matching output sequence length. The rate matching output sequence length E may be predetermined depending on the type of channel, the type of control information, the amount of resources mapped to channel or control information, and/or the number of code blocks used for transmission of control information. For example, the rate matching output sequence length E for a BCH is 864, the rate matching output sequence length E for is 864, and the rate matching output sequence length E for UCI may be predetermined based on the number of OFDM symbols carrying the UCI, the number of RBs, a spreading factor, the number of code blocks for the UCI, and/or the type of UCI included in a UCI payload (e.g., HARQ-ACK, scheduling request (SR), channel state information (CSI), etc.).

For any information block encoded to N bits, a same Polar sequence $\mathbf{Q}_0^{N-1} = \{Q_0^N, Q_1^N, Q_2^N,..., Q_{N-1}^N\}$ is used. The Polar sequence $\mathbf{Q}_0^{N-1}$ is a subset of Polar sequence $\mathbf{Q}_0^{Nmax-1}$ with all elements $Q_i^{Nmax}$ of values less than N, ordered in ascending order of reliability $W(Q_0^N)<W(Q_1^N)<W(Q_2^N)<...<W(Q_{N-1}^N)$.

In the NR system, under specific conditions such as when 18 <= polar code information size <= 25, parity check bits are generated to improve performance (e.g., block error rate (BLER)) when using polar codes. Here, a polar code information size K refers to the number of information bits encoded through polar coding. For example, the sum of code block bits and code block CRC bit(s) may be equivalent to the polar code information size.

FIG. 12 illustrates a method of generating parity check bit(s) used in polar codes.

In some implementations, a parity check (PC) polar code may be used. The PC polar code refers to a polar code that places PC bit(s) generated using a portion of a data block (i.e., information block) in the input of a polar encoder. According to the currently published NR specifications, the PC polar code may be used when the data block size K is within a range of $18 <= K <= 25$. In this case, the number of PC bits is 3, and the PC bits may be generated using a 5-bit shift register as illustrated in FIG. 12. In FIG.12, the 5-bit shift register, i.e., $y[0]$, $y[1]$, $y[2]$, $y[3]$, and $y[4]$, are all initialized to 0. That is, PC bit(s) may be generated for a data block $[u_0, u_1, u_2, ..., u_{N-1}]$ as follows.

> The register is cyclically shifted to the left.
> If $u_i$ is an information bit, set $y[0] = (u_i$ XOR $y[0])$,
> If $u_i$ is a PC bit, set $u_i = y[0]$.

The generated PC bit(s) are assigned to input bit channels (i.e., the bit indices of the polar code) of the polar encoder as follows. When $E - K + 3 > 192$, $n^{wm}_{PC} = 1$, and when $E - K + 3 <= 192$, $n^{wm}_{PC} = 0$. In this case, if a set of bit indices for the PC bits is denoted as $\mathbf{Q}^N_{PC}$, and if a set of bit indices for other PC bits among $\mathbf{Q}^N_{PC}$ is denoted as $\mathbf{Q}^N_{PC\_wm}$, the size of the set $\mathbf{Q}^N_{PC}$ is $|\mathbf{Q}^N_{PC}| = n_{PC}$, and the size of the set $\mathbf{Q}^N_{PC\_wm}$ is $|\mathbf{Q}^N_{PC\_wm}| = \mathbf{n}^{wm}_{PC}$. According to the NR specifications (e.g., 3GPP TS 38.212 Rel-15), $\mathbf{Q}^N_{PC}$ and $\mathbf{Q}^N_{PC\_wm}$ may be calculated as follows. For a bit index j ranging from 0 to N - 1 (i.e., $j = 0, 1, ..., N-1$), the j-th row of $\mathbf{G}_N$ is denoted as $\mathbf{g}_j$, and the row weight of $\mathbf{g}_j$ is denoted as $w(\mathbf{g}_j)$, where $w(\mathbf{g}_j)$ is the count of ones within $\mathbf{g}_j$. In this case, $(n_{PC} - n^{wm}_{PC})$ PC bits are placed on $(n_{PC} - n^{wm}_{PC})$ least reliable bit indices in $\overline{\mathbf{Q}}^N_I$. In addition, the remaining $n^{wm}_{PC}$ PC bits are placed on bit indices with the minimum row weight in $\overline{\mathbf{Q}}^N_I$, where $\widetilde{\mathbf{Q}}^N_I$ denotes $(|\overline{\mathbf{Q}}^N_I| - n_{PC})$ most reliable bit indices. If there are more bit indices with the same minimum row weight in $\widetilde{\mathbf{Q}}^N_I$ than $n^{wm}_{PC}$, the remaining $n^{wm}_{PC}$ PC bits are placed on $n^{wm}_{PC}$ bit indices with the highest reliability and the minimum row weight in $\widetilde{\mathbf{Q}}^N_I$.

In some implementations, the input to polar encoding, $\mathbf{u} = [u_0\, u_1\, u_2\, ... \, u_{N-1}]$ may be generated according to Table 5 below.

Table 5

$$k = 0;$$

$$\text{if } n_{PC} > 0$$

$$y_0 = 0; \; y_1 = 0; \; y_2 = 0; \; y_3 = 0; \; y_4 = 0;$$

$$\text{for } n = 0 \text{ to } N - 1$$

$$y_t = y_0; \; y_0 = y_1; \; y_1 = y_2; \; y_2 = y_3; \; y_3 = y_4; \; y_4 = y_t;$$

$$\text{if } n \in \overline{\mathbf{Q}}_I^N$$

$$\text{if } n \in \mathbf{Q}_{PC}^N$$

$$u_n = y_0;$$

$$\text{else}$$

$$u_n = c_k^{'};$$

$$k = k + 1;$$

$$y_0 = y_0 \oplus u_n;$$

$$\text{end if}$$

$$\text{else}$$

$$u_n = 0;$$

$$\text{end if}$$

$$\text{end for}$$

$$\text{else}$$

$$\text{for } n = 0 \text{ to } N - 1$$

$$\text{if } n \in \overline{\mathbf{Q}}_I^N$$

$$u_n = c_k^{'};$$

$$k = k + 1;$$

$$\text{else}$$

$$u_n = 0;$$

$$\text{end if}$$

$$\text{end for}$$

$$\text{end if}$$

The output after encoding, $\mathbf{d} = [d_0 \; d_1 \; d_2 \; d_3 \; ... \; d_{N-1}]$ is obtained from $\mathbf{d} = \mathbf{u}\mathbf{G}_N$, and the encoding is performed by GF(2).

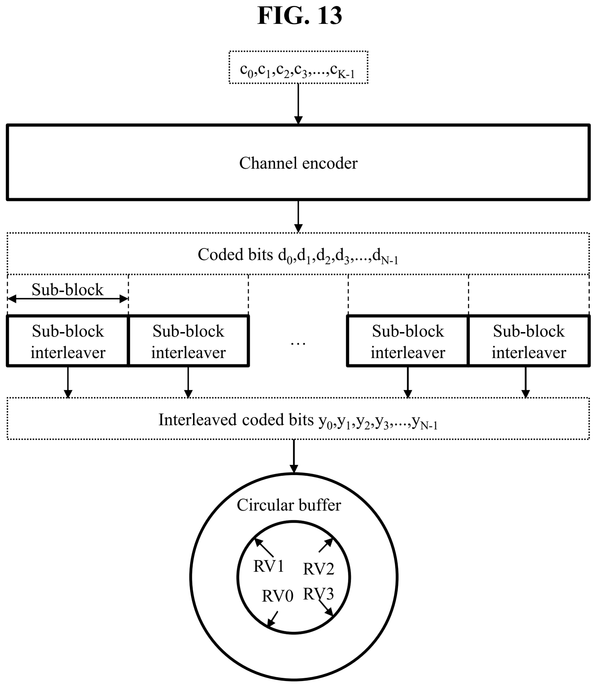

FIG. 13 is a diagram to explain a rate matching process according to some implementations of the present disclosure.

In some implementations, rate matching is performed after channel coding. In the NR specifications, rate matching for polar codes is defined for each code block, and the rate matching consists of sub-block interleaving, bit selection, and bit interleaving. In this specification, an input bit sequence before rate matching may be denoted as $d_0$, $d_1$,

$d_2, d_3, ..., d_{N-1}$, and an output bit sequence after rate matching may be denoted as $f_0, f_1, f_2, f_3, ..., f_{E-1}$. Bits input to a sub-block interleaver are coded bits $d_0, d_1, d_2, d_3, ..., d_{N-1}$. The coded bits $d_0, d_1, d_2, d_3, ..., d_{N-1}$ may be divided into 32 sub-blocks. Bits output from the sub-block interleaver may be denoted as $y_0, y_1, y_2, y_3, ..., y_{N-1}$, which may be generated as follows: for n = 0 to N-1: i = floor(32n / N); J(n) = P(i) * (N / 32) + mod(n, N / 32); $y_n = d_{J(n)}$, where a sub-block interleaver pattern P(i) is determined according to Table 6 below.

Table 6

| i | P(i) | i | P(i) | i | P(i) | i | P(i) | i | P(i) | i | P(i) | i | P(i) | i | P(i) |
|---|------|---|------|----|------|----|------|----|------|----|------|----|------|----|------|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

$\mathbf{G}_N = (\mathbf{G}_2)^{\otimes n}$ denotes the n-th Kronecker power of the matrix $\mathbf{G}_2$, where N is $2^n$ and $\mathbf{G}_2$ is the same as the basic matrix F shown in FIG. 6(b).

In some implementations, the bit sequence $y_0, y_1, y_2, y_3, ..., y_{N-1}$ after the sub-block interleaver is written into a cyclic buffer of length N. If the rate matching output sequence length is denoted as E, a bit selection output bit sequence $e_k$ (where k = 0, 1, 2, ..., E-1) may be generated as follows.

Table 7

if $E \geq N$  -- repetition

$\quad$ for $k = 0$ to $E - 1$

$\qquad e_k = y_{\mathrm{mod}(k,N)}$ ;

$\quad$ end for

else

$\quad$ if $K / E \leq 7/16$   -- puncturing

$\qquad$ for $k = 0$ to $E - 1$

$\qquad\quad e_k = y_{k+N-E}$ ;

$\qquad$ end for

$\quad$ else   -- shortening

$\qquad$ for $k = 0$ to $E - 1$

$\qquad\quad e_k = y_k$ ;

$\qquad$ end for

$\quad$ end if

end if

Puncturing or shortening is a technique where some of the encoded bits are not transmitted when resources allocated for transmission are not large enough to accommodate all the encoded bits. Repetition is a technique where some of the encoded bits are duplicated and transmitted when resources allocated for transmission are large enough to accommodate all the encoded bits.

Depending on the type of transport channel or control information or depending on the channel coding scheme, a bit sequence $e_0, e_1, e_2, ..., e_{E-1}$ may be interleaved into the bit sequence $f_0, f_1, f_2, f_3, ..., f_{E-1}$. For example, in the case of polar coding for UCI, the bit sequence $e_0$, $e_1$, $e_2$, ..., $e_{E-1}$ may be interleaved into the bit sequence $f_0$, $f_1$, $f_2$, $f_3$, ..., $f_{E-1}$ as follows.

Table 8

Denote $T$ as the smallest integer such that $T(T+1)/2 \geq E$;

$k = 0$;

for $i = 0$ to $T - 1$

    for $j = 0$ to $T - 1 - i$

      if $k < E$

        $v_{i,j} = e_k$;

      else

        $v_{i,j} = < NULL >$;

      end if

      $k = k + 1$;

    end for

end for

$k = 0$;

for $j = 0$ to $T - 1$

    for $i = 0$ to $T - 1 - j$

      if $v_{i,j} \neq < NULL >$

        $f_k = v_{i,j}$;

        $k = k + 1$

      end if

    end for

end for

else

    for $i = 0$ to $E - 1$

      $f_i = e_i$;

    end for

A set of bit indices in the polar sequence $\mathbf{Q}_0^{N-1}$ is denoted as $\overline{\mathbf{Q}}_I^N$ , and a set of other bit indices in the polar sequence $\mathbf{Q}_0^{N-1}$ is denoted as $\overline{\mathbf{Q}}_F^N$ , where $\left|\overline{\mathbf{Q}}_I^N\right| = K + n_{PC}$, $\left|\overline{\mathbf{Q}}_F^N\right| = N - \left|\overline{\mathbf{Q}}_I^N\right|$ , and $n_{PC}$ is the number of PC bits. In the present disclosure, |S| denotes the number of elements in a set S. In some implementations, $\overline{\mathbf{Q}}_I^N$ and $\overline{\mathbf{Q}}_F^N$ may be given as follows.

Table 9

$$\overline{\mathbf{Q}}_{F,tmp}^{N} = \varnothing$$

if $E < N$

if $K/E \le 7/16$  -- puncturing

for $n = 0$ to $N - E - 1$

$$\overline{\mathbf{Q}}_{F,tmp}^{N} = \overline{\mathbf{Q}}_{F,tmp}^{N} \cup \{J(n)\};$$

end for

if $E \ge 3N/4$

$$\overline{\mathbf{Q}}_{F,tmp}^{N} = \overline{\mathbf{Q}}_{F,tmp}^{N} \cup \{0,1,\ldots,\lceil 3N/4 - E/2 \rceil - 1\};$$

else

$$\overline{\mathbf{Q}}_{F,tmp}^{N} = \overline{\mathbf{Q}}_{F,tmp}^{N} \cup \{0,1,\ldots,\lceil 9N/16 - E/4 \rceil - 1\};$$

end if

else    -- shortening

for $n = E$ to $N - 1$

$$\overline{\mathbf{Q}}_{F,tmp}^{N} = \overline{\mathbf{Q}}_{F,tmp}^{N} \cup \{J(n)\};$$

end for

end if

end if

$$\overline{\mathbf{Q}}_{I,tmp}^{N} = \mathbf{Q}_{0}^{N-1} \setminus \overline{\mathbf{Q}}_{F,tmp}^{N};$$

$\overline{\mathbf{Q}}_{I}^{N}$ comprises $(K + n_{PC})$ most reliable bit indices in $\overline{\mathbf{Q}}_{I,tmp}^{N}$;

$$\overline{\mathbf{Q}}_{F}^{N} = \mathbf{Q}_{0}^{N-1} \setminus \overline{\mathbf{Q}}_{I}^{N};$$

In the present disclosure, **A\B** denotes the difference of set **B** from set **A,** i.e., **A - B.** In other words, **A\B** refers to a set of all elements of set A that do not belong to set **B.**

As described above, polar codes are designed based on the channel polarization characteristics through repeated connections of short kernel codes. Based on the reliability of polarized bit channels obtained through channel polarization, information bits **A** are transmitted on channels with high reliability. polar codes are set to frozen bits **F,** which are shared between the transmitter and receiver in advance, are set on channels with low reliability. A polar code is decoded through a recursive SC decoder or successive cancellation list (SCL) decoder.

Accordingly, polar codes are designed such that a transmission message is placed on a bit channel with high reliability generated through channel polarization and a pre-shared value is placed on a bit channel with low reliability. However, the polar codes designed as described above may achieve optimal performance for SC decoders, but the polar codes may experience performance degradation when SCL decoders are used. In other words, conventional polar codes are designed by selecting information sets optimized for SC decoders or by selecting information sets that maximize the minimum distance. However, when a practical-sized SCL decoder is used, high error correction performance is not be achieved. Therefore, research is ongoing regarding design methods of polar codes that enable high error correction performance to be achieved for practically used SCL decoders. As part of this research, the Reed-Muller (RM) polar code, which analyzes RM codes with polar codes and utilizes the large minimum distance characteristic of the RM codes, has been proposed (see the following reference: Li, Bin, Hui Shen, and David Tse. "A RM-polar codes."). Due to the design that reflects only the minimum distance and does not incorporate SC decoding, higher error correction performance compared to SC-based polar codes may be achieved by the RM polar code only when a large list-sized SCL decoder is used. However, since channel characteristics are not reflected in the code design process, performance degradation occurs when practical list-sized SCL decoders (e.g., L = 8 to 32) are used for the RM polar code. Therefore, there is a need for polar codes that enable high error correction performance to be achieved for practical-sized SCL decoders.

Hereinafter, implementations of the present disclosure regarding the design/decision techniques of polar codes optimized for minimum distance will be described. The implementations relate to polar codes that maintain the high minimum distance characteristics of the code while improving SC decoding performance to achieve high decoding performance at practical list sizes.

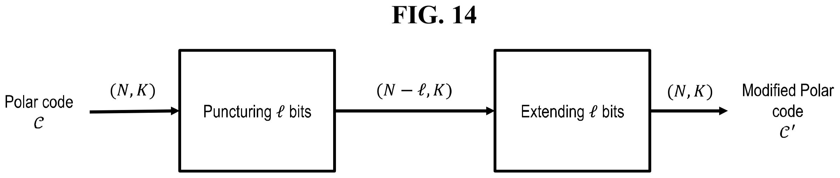

FIG. 14 illustrates a process of determining polar codes according to some implementations of the present disclosure.

According to some implementations of the present disclosure, as shown in FIG. 14, a polar code *C* having an information set optimized for minimum distance (e.g., RM-polar code) is first designed or determined, and design freedom is obtained through puncturing of unnecessary encoded bit(s) from bits encoded by the polar code *C*. For the puncturing process, a puncturing pattern that maintains the minimum distance as much as possible through the analysis of the minimum distance characteristics of the code after puncturing is designed or determined, whereby the good minimum distance characteristics of an original code are maintained. Subsequently, additional bits through extension are transmitted, whereby the performance of SC decoding is improved. Among bits generated at intermediate nodes in the butterfly network of a polar code, bit(s) which are capable of most improving the SC decoding performance of the code are selected as extension bit(s).

In the present disclosure, puncturing may refer to a technique of not transmitting some of the bits of a codeword, and extension may refer to a technique of generating additional parity bit(s).

In the present disclosure, a polar code with an information set optimized for minimum distance is used as the base code. As explained earlier, the generator matrix of the polar code is $\mathbf{G}_N = \mathbf{F}^{\otimes n}$, which is the n-th Kronecker power of matrix $\mathbf{F}$, where N=2" and $\mathbf{F}$ is shown in FIG. 6(b). The message of the polar code is placed in information set *A,* and the smallest Hamming weight among the Hamming weights of the rows corresponding to the positions of the information set has the same characteristic as the minimum distance. Therefore, by selecting an information set in the order of the highest Hamming weight based on a given message length, the information set optimized for minimum distance may be selected. If there are multiple information set candidates with the same Hamming weight, the information set is selected based on the performance of bit channels.

The design of a polar code according to some implementations of the present disclosure performs puncturing and extension sequentially.

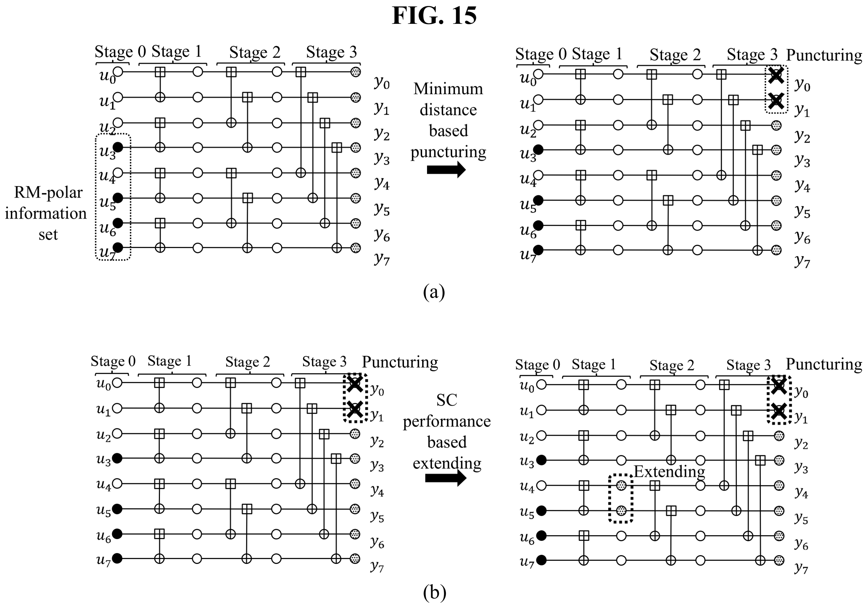

FIG. 15 is a diagram for explaining a puncturing pattern design and an extension pattern design according to some implementations of the present disclosure.

Referring to FIG. 15(a), the design of the puncturing pattern is performed on a bit-by-bit basis, and a puncturing pattern including $l$ puncturing bits is represented as $P^{(l\text{-}1)}$. The design of an $l$-th puncturing bit is as follows: First, when puncturing is performed on a candidate puncturing bit $b \in \mathbf{B} := [0:N\text{-}1] \backslash P^{(l\text{-}1)}$, the minimum distance codeword of the polar code is generated, and the minimum distance $d^{(l)}_{min}(P^{(l\text{-}1)} \cup \{b\})$ and the number of minimum distance codewords $A^{(l)}_{min}(P^{(l\text{-}1)} \cup \{b\})$ are calculated. The minimum distance codeword of the polar code may be generated using a large list-sized SCL decoder (reference: P. Yuan, T. Prinz, G. Boecherer, O. Iscan, R. Boehnke, and W. Xu, "Polar Code Construction for List Decoding," SCC 2019; 12th International ITG Conference on Systems, Communications and Coding, 2019, pp. 1-6, doi: 10.30420/454862022). Based on the calculated minimum distance, a set of candidate puncturing bits that enable the minimum distance to be maintained as much as possible is selected as follows.

Equation 14

$$P = \left\{ p \,\middle|\, d^{(\ell)}_{min}\left(P^{(\ell-1)} \cup \{p\}\right) = \max_{b \in B}\left(d^{(\ell)}_{min}\left(P^{(\ell-1)} \cup \{b\}\right)\right) \right\}$$

If set **P** includes only one candidate bit, the 1-th puncturing bit is selected by $p^{(l)} = p \in \mathbf{P}$. If $|\mathbf{P}| > 1$, a bit that minimizes the number of minimum distance codewords is selected as shown in the following equation.

Equation 15

$$p^{(\ell)} = \arg\min_{b \in P}\left(A_{min}^{(\ell)}(b)\right)$$

The design of the puncturing pattern is carried out up to a predetermined length $l_{max}$.

Referring to FIG. 15(b), in some implementations of the present disclosure, the SC decoding performance is improved through extension based on the punctured code. Extension is a technique for transmitting new parity bits by generating the new parity bits from an existing codeword. A representative example is a repeated transmission method, where previously transmitted codeword bits are repeatedly transmitted. The repeated transmission method has the advantage of not requiring additional decoding complexity for the newly generated parity bits, allowing the decoder of the existing code to be used as it is.

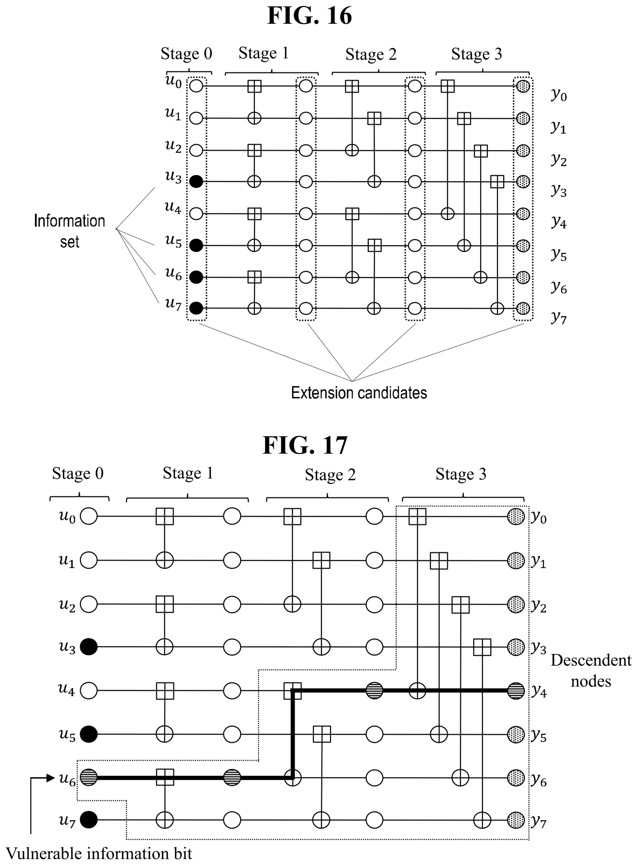

FIG. 16 illustrates extension candidate bits available for extension in some implementations of the present disclosure. In FIG. 16, the values corresponding to each node (indicated by circles in FIG. 16) may become the extension candidate bits.

By utilizing the characteristic that codewords for polar codes are generated through butterfly network operations as shown in FIG. 16, if intermediate nodes within a butterfly network are additionally transmitted, then encoding/decoding may be performed without additional complexity. During the encoding process of the code, the values of the intermediate nodes are automatically calculated, and the additionally transmitted reliability is used in the decoding process by adding extra reliability information to the intermediate nodes. This allows the existing polar code decoder structure to be maintained while utilizing the information that is additionally transmitted. Therefore, in the present disclosure, an extension pattern is designed to maximize SC decoding performance through extension by including all nodes within a butterfly network, including codeword bits.

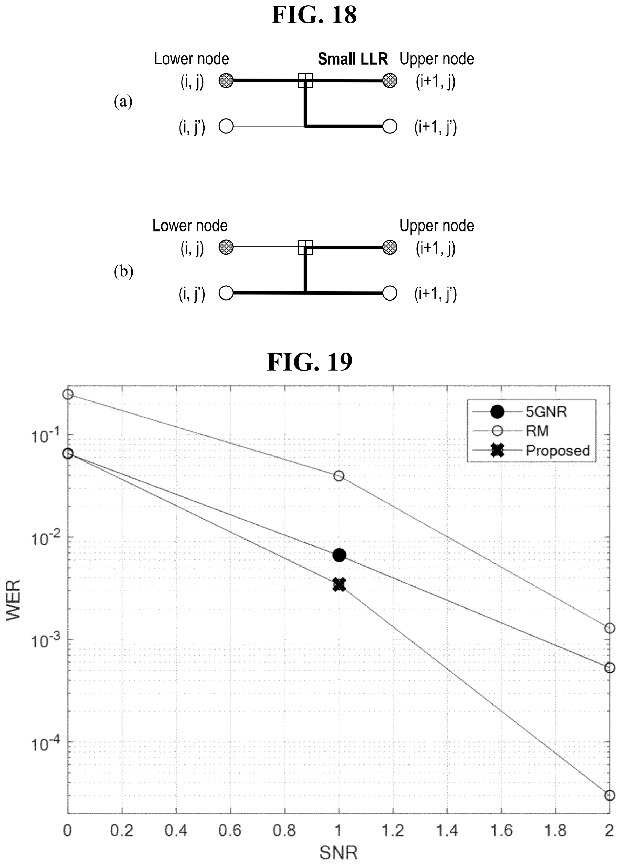

FIGS. 17 and 18 are diagrams for explaining a process of selecting extension bits at each layer in a polar code butterfly network. In the butterfly network of FIGS.17 and 18, nodes located closer to the input side may be referred to as ancestor nodes, while nodes located on the output side may be referred to as descendant nodes.

The SC decoder of polar codes allows for theoretical performance analysis through methods such as DE (density evolution) and GA (Gaussian approximation) (reference: D. Wu, Y. Li, and Y. Sun, "Construction and Block Error Rate Analysis of Polar Codes Over AWGN Channel Based on Gaussian Approximation," in IEEE Communications Letters, vol. 18, no. 7, pp. 1099-1102, July 2014). Through these methods, it is possible to evaluate the decoding performance after extension for candidate extension bits. However, the number of candidate extension bits including intermediate nodes is O(MogN), which requires high search complexity when the code length is large. Therefore, in the implementations of the present disclosure, when low-complexity design is needed, candidate extension bit(s) are selected through the analysis of the propagation structure of log-likelihood ratio (LLR) messages during a polar code decoding process.

In the theoretical performance evaluation process of a code, the reliability of each information bit may be assessed, and thus, vulnerable information bits that play a key role in the performance degradation of the code may be detected. Since the reliability of nodes determines the overall performance of the code, as illustrated in FIG. 17, extension candidate bit(s) are selected from the descendant nodes of the vulnerable information bits. During a process to extending the descendant nodes, a node that contributes more significantly is selected from among descendant extension candidate nodes based on the position of an ancestor vulnerable node within the kernel. Here, the ancestor vulnerable node refers to a node located closer to the input side of a butterfly network, i.e., an ancestor node, among nodes located in a process that starts from a vulnerable information bit and extends to descendant nodes. Referring to FIG. 17, a corresponding node is set as the ancestor node, starting from a vulnerable information bit $u_6$, and one of the descendant nodes located in stage 1 of the node may be selected as a candidate extension bit. Next, a candidate extension node selected in stage 1 is determined as the ancestor vulnerable node, and a process of selecting one of the descendant nodes located in stage 2 of the node as a candidate extension bit may be repeated. First, as shown in FIG. 18(a), when the ancestor vulnerable node is located at the top of the kernel, the reliability of the descendant nodes is propagated through the boxplus operation as shown in the following equation.

Equation 16

$$x \boxplus y = \ln\frac{\cosh\left(\frac{x+y}{2}\right)}{\cosh\left(\frac{x-y}{2}\right)} \cong sign(x) \cdot sign(y) \cdot \min(|x|, |y|)$$

In this case, since a lower LLR value is determined by an input in the boxplus operation, a node with lower reliability among the descendant nodes is prioritized as a candidate extension node. If an ancestor vulnerable node is located at the bottom of the kernel as shown in FIG. 18(b), a descendant node located at the top propagates the reliability through the boxplus operation, while a descendant node located at the bottom propagates the reliability through the "+" operation. Therefore, the descendant node located at the bottom, which directly transfers messages, is prioritized as a candidate extension node. Accordingly, one extension candidate bit is selected for each network layer, and the extension pattern may be designed with a total search complexity of $O(\log N)$. Additionally, considering the puncturing pattern, nodes with reliability of 0 are added to the extension candidate nodes as needed.

The optimal number of extension and puncturing bits, $l_{max}$, in the design of polar codes is set as the limit of SC performance gains that may be achieved through the extension of the code. After puncturing certain bits in the code design process, puncturing bits that are restored during the extension process occur, and this is the point where the restoration of punctured bits takes precedence over the SC decoding performance gain that may be achieved through the extension of intermediate nodes. Therefore, in the actual design of the puncturing and extension patterns, the point at which the puncturing bits are included in the extension pattern is set as the number of extension and puncturing bits.

The following table shows puncturing and extension patterns designed according to some implementations of the present disclosure for a polar code with a mother code size of N = 256 and an input information bit size K = 93, i.e., (N, K) = (256, 93).

Table 10

| | Pattern | | | | | |
|---|---|---|---|---|---|---|
| **Puncturing** | [0,1,2,4,8,16,32,63,64,128,195,77,150,103,250,17,74,179,30,225,121,149,43.252] | | | | | |
| **Extending** | [19,4; 33,4; 49,3; 26,3; | 64,4; 32,5; 58,6; 44,2; | 64,5; 33,5; 17,6; 13,6; | 65,4; 16,4; 81,3; 60,6; | 128,4; 30,6; 8,7; 2,7; | 51,7; 63,7; 43,7; 57,6] |

Referring to Table 10, for a polar code with N = 256, where output bit indices are y0 to y255, based on a puncturing pattern of [0, 1, 2, 4, 8, 16, 32, 63, 64, 128, 195, 77, 150, 103, 250, 17, 74, 179, 30, 225, 121, 149, 43, 252], the bit values at output bit indices y0, y1, y2, y4, y8, y16, y32, y63, y64, y128, y195, y77, y150, y103, y250, y17, y74, y179, y30, y225, y121, y149, y43, y252 may be punctured. In Table 10, the extension pattern may represent the positions of bits being extended in the graph structure of the polar code shown in FIG. 16. For example, in the case of (19, 4), the bit value corresponding to the 19th row (i.e., row index 19) in stage 4 may be used as an extension bit. This bit may be input into one of the positions to be punched according to the puncturing pattern.

FIG. 19 illustrates the word error rate (WER) performance of a polar code according to some implementations of the present disclosure. In particular, FIG. 19 shows the WER performance of (N, K) = (253, 93) polar codes designed according to some implementations of the present disclosure, 5G NR standard polar codes, and RM codes, using an L=16 SCL decoder and assuming an additive white Gaussian noise (AWGN) channel. Referring to FIG. 19, it may be confirmed that the polar code according to some implementations of the present disclosure achieves an error rate performance improvement of more than 10 times compared to the existing 5G NR standard and RM codes. This shows that the polar code according to some implementations of the present disclosure maintain the minimum distance characteristics of the code and achieve improved error correction performance for practical list-sized SCL decoders through SC decoding performance gains obtained via extension. Since the polar code according to some implementations of the present disclosure may achieve error rate performance gains without additional encoding/decoding complexity while maintaining the structure of the existing code, the applicability is expected to be significant.

When the polar code according to the implementations of the present disclosure are commercialized, the polar codes may be utilized as a core technology for data or control channels in environments requiring ultra-reliable and low-latency communication. When a practical-sized SCL decoder is used, the codes designed according to the present disclosure show superior error correction performance under various conditions, compared to the polar codes previously used in the 5G standard. The polar codes are guaranteed to have significant market potential as a core technology for ultra-reliable and low-latency communications (URLLC) in 6G communications.

Research is ongoing regarding the design methods of polar codes capable of achieving high error correction performance for SCL decoders. In this process, technologies related to polar subcodes, which include parity information bits (reference: P. Trifonov and V. Miloslavskaya, "Polar Subcodes," in IEEE Journal on Selected Areas in Communications, vol. 34, no. 2, pp. 254-266, Feb. 2016), have been proposed. However, since the design technique of the codes is optimized according to the design parameters of the code, it is difficult to apply the codes in practical environments that require various message lengths. Therefore, considering practical industrial aspects, there is a need for code design techniques with a nested structure that supports various message lengths. To address this, the present disclosure proposes a nested polar code design technique.

The nested polar code design technique proposed in the present disclosure is a nested polar code design technique for pre-designing a nested code set optimized for minimum distance based on supported message lengths, thereby improving SCL decoding performance through the puncturing and extension of some bits in codes included in the set. In this case, considering practical implementation, nested puncturing and extension patterns optimized for the code set are utilized.

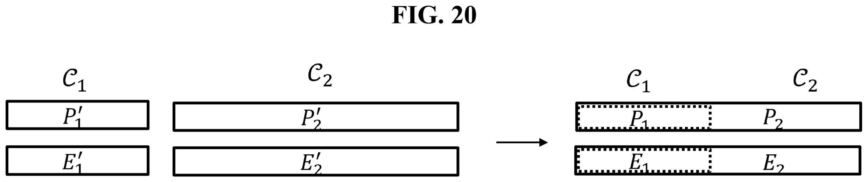

FIG. 20 is a diagram for explaining the concept of a nested puncturing pattern and an extension pattern.

The design of a nested polar code proposed in the present disclosure sequentially performs puncturing and extension on a given set of nested polar codes. In this case, for the set of codes $C_1, C_2, ..., C_t$, the puncturing and extension patterns for each code are represented as $P_i$ and $E_i$, respectively. The puncturing and extension patterns are designed to satisfy: $P_1 \subseteq P_2 \subseteq ... \subseteq P_t$, $E_1 \subseteq E_2 \subseteq ... \subseteq E_t$, $|P_t|=|E_t|=I_{max}$, and thus the entire nested polar code is supported with a single puncturing and extension pattern.

As explained above, the design of the puncturing pattern is performed on a bit-by-bit basis. To maintain the minimum distance as much as possible after puncturing for a code, whether the minimum distance decreases after puncturing for candidate puncturing bits is determined, whereby a puncturing bit that enables the minimum distance to be maintained is selected. When a puncturing pattern including 1-1 puncturing bit(s) is represented as $P^{(l-1)}$, the design of the an 1-th puncturing bit involves selecting a candidate puncturing bit $b \in \mathbf{B}:=[0:N-1]\backslash P^{(l-1)}$. When puncturing is performed on the candidate puncturing bit, the minimum distance codeword of the polar code is generated using an SCL decoder. The minimum distance $d^{(l)}_{min}(P^{(l-1)} \cup \{b\})$ and the number of minimum distance codewords $A^{(l)}_{min}(P^{(l-1)} \cup b)$ are calculated after puncturing. Accordingly, the decrease in the minimum distance caused by each candidate puncturing bit may be calculated as shown in the following equation.

Equation 17

$$f\left(\mathcal{C}, P^{(\ell-1)}, p\right) = d^{(\ell-1)}_{\min}(P^{(\ell-1)}) - d^{(\ell)}_{\min}(P^{(\ell-1)} \cup \{p\}) \in \{0,1\}$$

In Equation 17, $d^{(l)}_{min}$ refers to the minimum distance after 1-th puncturing, and $P^{(l)}$ represents a set of 1 puncturing bits.

The design of an integrated puncturing pattern selects puncturing bits that minimize the number of codes where the minimum distance decreases after puncturing is performed for each candidate puncturing bit for codes $C_1, C_2, ..., C_t$. There are differences in the number of optimal puncturing/extension bits required for each code, and a set of codes to which each puncturing bit contributes differs. Therefore, when the optimal number of puncturing/extension bits for code $C_i$ is denoted as $l_i$, corresponding puncturing bits contribute to code $C_i$ only if $1 <= 1_i$, where 1 is the number of puncturing bits currently being designed. Thus, the puncturing bits may be determined as follows.

Equation 18

$$p^{(\ell)} = \arg\min_b \sum_{i=1}^{t} f\left(\mathcal{C}_i, P^{(\ell-1)}, p\right) I(\ell_i \geq \ell),$$

$$I(X) = \begin{cases} 1, & \text{if } X = \textbf{True}, \\ 0, & \text{otherwise} \end{cases}$$

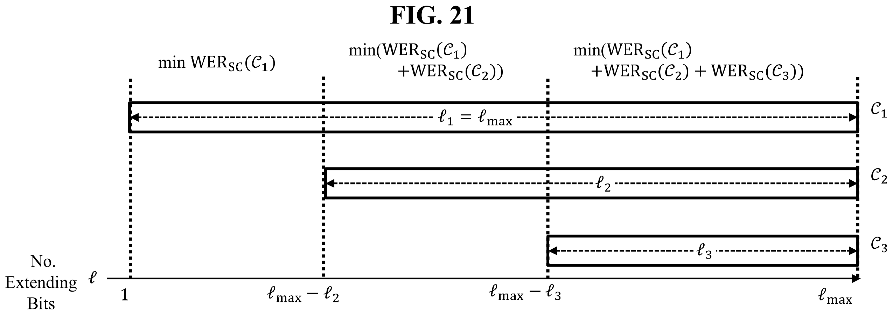

FIG. 21 is a diagram for explaining a method of determining integrated extension pattern(s) according to some implementations of the present disclosure. In FIG. 21, $WER_{SC}$ represents the WER performance of an SC decoder, and $E^{(l)}$ represents a set of 1 extension bits.

According to some implementations of the present disclosure, the SC decoding performance of a code is improved through nested extension based on a punched code. Extension is a technique for generating and transmitting new parity bits from an existing codeword. In the case of polar codes, intermediate nodes $e \in I$ within a butterfly network may be utilized as parity bits as shown in FIG. 16 based on the characteristic that codewords are generated through butterfly network operations. The values of the intermediate nodes are automatically calculated during the encoding process of the code. The additionally transmitted reliability is used in the decoding process by adding extra reliability information to the intermediate nodes. This allows the existing polar code decoder structure to be maintained while utilizing the information that is additionally transmitted. The extension pattern may be determined, for example, by selecting extension bit(s) that enable SC decoding performance to be maximized through the evaluation of SC decoding performance after extension. As mentioned above, SC decoding performance may be theoretically analyzed through Gaussian approximation (GA). When the WER performance after SC decoding of a code obtained by puncturing for code $\mathbf{C}$ with puncturing pattern $\mathbf{P}$ and extending extension bit(s) e according to extension pattern $\mathbf{E}$ is expressed as $WERsc(\mathbf{C}, \mathbf{P}, \mathbf{E} \cup \{e\})$, an integrated extension pattern may be determined by selecting extension bit(s) capable of maximizing the SC decoding performance of codes $C_1, C_2, ..., C_t$. The integrated extension metric is configured as the sum of the WER performance of SC decoding for each code. Similar to the design/decision process of puncturing bit(s), each extension bit contributes to a different set of codes, and since extension occurs after puncturing, an 1-th extension bit contributes to code $C_i$ only when $l_{max} - l_i < 1$, as shown in FIG. 21. The extension bit may be determined as follows.

Equation 19

$$e^{(\ell)} = \arg\min_{e \in I} \sum_{i=1}^{t} \text{WER}_{\text{SC}} \left( \mathcal{C}_i,\, P,\, E^{(\ell-1)} \cup \{e\} \right) I(\ell_{\max} - \ell_i < \ell)$$

The designed or determined puncturing pattern and extension pattern may be used as $P_i = P(l:1_i)$ and $E_i = E(l_{max} - l_i : l_{max})$ according to the required conditions of the code. In some implementations of the present disclosure, the puncturing pattern and extension pattern may be hierarchically designed/determined to support a certain range, depending on the performance requirements and implementation complexity of the application or system.

The following table shows puncturing and extension patterns for nested polar codes designed/determined according to some implementations of the present disclosure. The codes used for determining the puncturing and extension patterns in the table are as follows: $(N, K) = (256, 93)$ code, $(N, K) = (246, 163)$ code, and $(N, K) = (256, 219)$ code. For a $(256, 93)$ code, $1_1 = 30$, for a $(246, 163)$ code, $1_2 = 22$, and for a $(256, 219)$ code, $1_3 = 10$ are set.

Table 11

| | Pattern | | | | |
|---|---|---|---|---|---|
| **Puncturing** | [0,1,2,4,8,16,32,63,64,128,195,77,150,103,250,17,74,179,30,225,121,149,43,252,56,205,10, 93,223,68] | | | | |
| **Extending** | [0,5; 32,4; 48,3; 64,4; 8,6; | 4,6; 56,6; 74,5; 4,5; 8,5; | 63,6; 39,6; 12,5; 22,6; 30,6; | 24,5; 32,4; 64,4; 51,7; 67,7; | 1,4; 2,6; 31,5; 4,7; 8,7; | 16,7; 0,5; 1,7; 9,4; 32,3] |

Referring to Table 11, for a polar code with N = 256, where output bit indices are y0 to y255, based on a puncturing pattern [0, 1, 2, 4, 8, 16, 32, 63, 64, 128, 195, 77, 150, 103, 250, 17, 74, 179, 30, 225, 121, 149, 43, 252, 56, 205, 10, 93, 223, 68], the bit values at the corresponding output bit indices may be punctured. In Table 11, the extension pattern may represent the positions of bits being extended in the graph structure of the polar code shown in FIG. 16. For example, in the case of (0,5), the bit value corresponding to the 0th row (i.e., row index 0) in stage 5 of the node can be used as an extension bit value. This bit value may be input into one of the positions to be punctured according to the puncturing pattern.

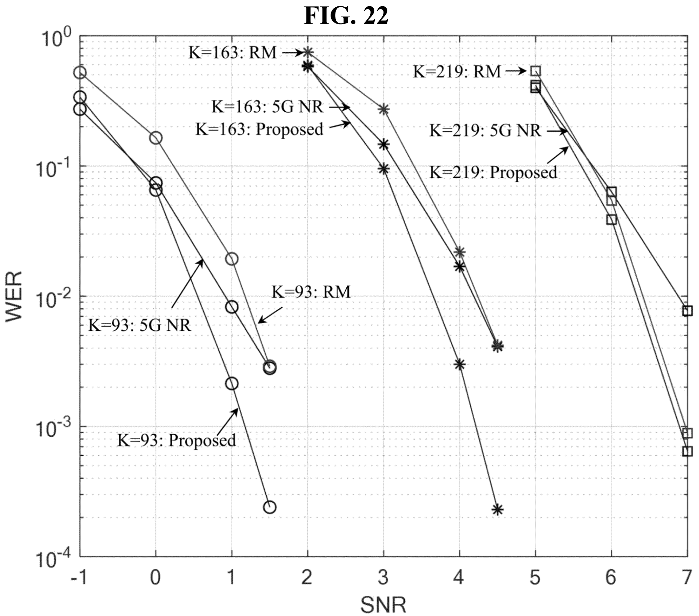

FIG. 22 illustrates the WER performance of a code designed/determined according to some implementations of the present disclosure, a 5G NR standard polar code, and an RM code when SCL decoding is used. Specifically, FIG. 22 illustrates the WER performance of the code designed/determined according to some implementations of the present disclosure, the 5G NR standard polar code, and the RM code for polar codes with N = 256 and K {93, 163, 219} under SCL decoding of L = 32. In FIG. 22 an AWGN channel is assumed.

In some implementations of the present disclosure mentioned above, puncturing according to a puncturing pattern and extension according to an extension pattern are part of an encoding process performed based on polar codes and are used to determine a codeword. Thus, the puncturing and extension are different from puncturing in rate matching, where transmission of some bits of a codeword is dropped based on the amount of radio resources for the codeword and a code rate, and repetition in rate matching, where some or all of the bits of a codeword are repeated based on the radio resources for the codeword and the code rate.

According to some implementations of the present disclosure, polar codes with high error correction performance may be designed/determined without the need for additional decoding complexity.

In the puncturing process, a nested puncturing pattern that enables the minimum distance of nested codes to be maintained as much as possible is determined through the analysis of the minimum distance characteristics of a nested code set. In the extension process, an extension pattern is determined to improve an integrated performance metric where the SC decoding performance of the nested codes is considered. In each code, puncturing and extension are performed on the same number of bits, and improved error correction performance may be achieved with a code of the same length as the original code. Therefore, according to some implementations of the present disclosure, nested polar codes with high error correction performance may be designed or determined using a single nested puncturing and extension pattern, without the need for additional decoding complexity. Additionally, since polar code according to some implementations of the present disclosure is designed/determined based on existing polar codes, the polar codes provide backward compatibility with commercialized technologies. As a result, when the polar codes of the present disclosure are used as a core technology for 6G communication, significant market potential is guaranteed. When the polar code according to some implementations of the present disclosure are commercialized, the polar codes are expected to be used by communication equipment manufacturers or communication service providers.

When the polar code according to some implementations of the present disclosure are applied with practical-sized SCL decoding, superior error correction performance may be achieved under various conditions compared to the polar codes previously used. The polar code according to some implementations of the present disclosure may be used as a core technology for URLLC.

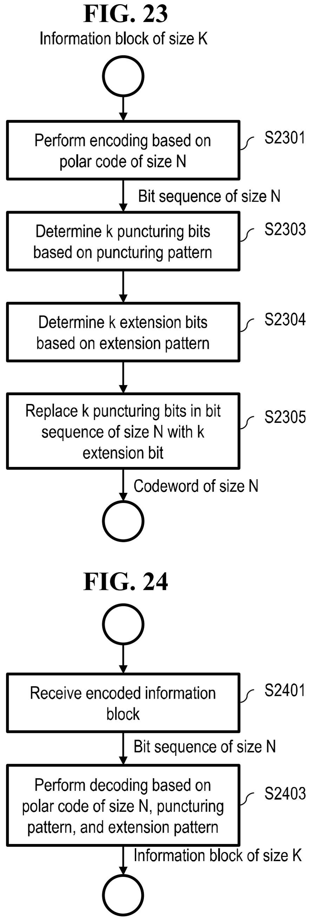

FIG. 23 illustrates a channel encoding process according to some implementations of the present disclosure.

A communication device or encoder may perform operations related to channel encoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or encoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure. Referring to FIG. 23, in the communication device, encoder, processing device, computer-readable (non-volatile) storage medium, and/or computer program product, the operations may include: determining a bit sequence of size N by encoding an information block of size K based on a polar code of size N (S2301); selecting k bit positions from N bit positions in the bit sequence based on a predetermined puncturing pattern (S2303); selecting k intermediate bit values from among intermediate bit values generated during the encoding of the information block based on the polar code of size N, based on a predetermined extension pattern (S2304); and generating a codeword of size N by replacing bit values at the k bit positions in the bit sequence with the k intermediate bit values (S2305).

In some implementations, the information block may be a TB with a TB CRC attached, which is obtained by adding the TB CRC to the TB, or a code block (CB) with a TB CRC attached, which is obtained by adding the CB CRC to the CB.

In some implementations, the operations may include: performing rate matching on the codeword based on a radio resource allocated for transmission of the codeword and a target code rate; and transmitting the rate-matched codeword over a physical channel using the radio resource. In some implementations, the physical channel may be, for example, a PUSCH or PDSCH, which are defined for data transport between the BS and UE, or a physical sidelink shared channel (PSSCH), which is defined for direct communication between UEs. The radio resource may be semi-statically configured and dynamically allocated by the BS to the UE. Alternatively, the UE may configure the radio resource to a peer UE, or the peer UE may configure the radio resource to the UE. In some implementations, information about the target code rate may be provided by the BS that allocate the radio resource, or the information may be provided by the UE to the peer UE.

In some implementations, the predetermined puncturing pattern may be one of a plurality of different puncturing patterns predetermined for a plurality of polar codes with at least different values of K or N. The plurality of different puncturing patterns may be predetermined such that a shorter puncturing pattern is a subset of a longer puncturing pattern.

In some implementations, the predetermined extension pattern may be one of a plurality of different extension patterns predetermined for a plurality of polar codes with at least different values of K or N. The plurality of different extension patterns may be predetermined such that a shorter extension pattern is a subset of a longer extension pattern.

FIG. 24 illustrates a channel decoding process according to some implementations of the present disclosure.

A communication device or decoder may perform operations related to channel decoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or decoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one computer-readable (non-volatile) storage medium and cause, when executed, (at least one processor) to perform the operations according to some implementations of the present disclosure. Referring to FIG. 24, in the communication device, decoder, processing device, computer-readable (non-volatile) storage medium, and/or computer program product, the operations may include: receiving an encoded information block (S2401); and determining an information block of size K by decoding the encoded information block based on a polar code of size N, a predetermined puncturing pattern, and a predetermined extension pattern (S2403).

In some implementations, the predetermined puncturing pattern may be used to select k bit positions from among N bit positions in a bit sequence of size N, which is generated based on the polar code of size N and the information block of size K. The predetermined extension pattern may be used to select k intermediate bit values from among intermediate bit values generated during the encoding of the information block of size N into the bit sequence. The encoded information block may be obtained from a codeword generated by replacing bit values at the k bit positions in the bit sequence with the k intermediate bit values.

In some implementations, the encoded information block may be a rate-matched codeword.

The information block may be a TB with a TB CRC attached, which is obtained by adding the TB CRC to the TB, or a CB with a TB CRC attached, which is obtained by adding the CB CRC to the CB.

In some implementations, the rate-matched codeword may be received over a physical channel using the radio resource allocated for the transmission of the encoded information block. In some implementations, the physical channel may be, for example, a PUSCH or PDSCH, which are defined for data transport between the BS and UE, or a PSSCH, which is defined for direct communication between UEs. The radio resource may be semi-statically configured and dynamically allocated by the BS to the UE. Alternatively, the UE may configure the radio resource to a peer UE, or the peer UE may configure the radio resource to the UE. In some implementations, information about a target code rate may be provided by the BS that allocate the radio resource, or the information may be provided by the UE to the peer UE.

The examples of the present disclosure as described above have been presented to enable any person of ordinary skill in the art to implement and practice the present disclosure. Although the present disclosure has been described with reference to the examples, those skilled in the art may make various modifications and variations in the example of the present disclosure. Thus, the present disclosure is not intended to be limited to the examples set for the herein, but is to be accorded the broadest scope consistent with the principles and features disclosed herein.

The implementations of the present disclosure may be used in a BS, a UE, or other equipment in a wireless communication system.

**Claims**

1. A method of encoding an information block for transmission by a communication device in a wireless communication system, the method comprising:

generating the information block of size K;
determining a bit sequence of size N by encoding the information block based on a polar code of size N;
selecting k bit positions from among N bit positions in the bit sequence based on a predetermined puncturing pattern;
selecting k intermediate bit values from among intermediate bit values generated during the encoding of the information block based on the polar code of size N, based on a predetermined extension pattern;
generating a codeword of size N by replacing bit values at the k bit positions in the bit sequence with the k intermediate bit values;
performing rate matching on the codeword based on a radio resource allocated for transmission of the codeword and a target code rate; and
transmitting the rate-matched codeword over a physical channel using the radio resource.

2. The method of claim 1, wherein the predetermined puncturing pattern is one of a plurality of different puncturing patterns predetermined for a plurality of polar codes with at least different values of K or N, and
wherein the plurality of different puncturing patterns are predetermined such that a shorter puncturing pattern is a subset of a longer puncturing pattern.

3. The method of claim 1, wherein the predetermined extension pattern is one of a plurality of different extension patterns predetermined for a plurality of polar codes with at least different values of K or N, and
wherein the plurality of different extension patterns are predetermined such that a shorter extension pattern is a subset of a longer extension pattern.

4. A communication device configured to encode an information block for transmission in a wireless communication system, the communication device comprising:

at least one transceiver;
at least one processor; and
at least one computer memory operably connected to the at least one processor and storing instructions that, when executed, cause the at least one processor to perform operations comprising:

generating the information block of size K;
determining a bit sequence of size N by encoding the information block based on a polar code of size N;
selecting k bit positions from among N bit positions in the bit sequence based on a predetermined puncturing pattern;
selecting k intermediate bit values from among intermediate bit values generated during the encoding of the information block based on the polar code of size N, based on a predetermined extension pattern;
generating a codeword of size N by replacing bit values at the k bit positions in the bit sequence with the k intermediate bit values;
performing rate matching on the codeword based on a radio resource allocated for transmission of the codeword and a target code rate; and
transmitting the rate-matched codeword over a physical channel using the radio resource.

5. A processing device in a wireless communication system, the processing device comprising:

at least one processor; and
at least one computer memory operably connected to the at least one processor and storing instructions that, when executed, cause the at least one processor to perform operations comprising:

generating an information block of size K;
determining a bit sequence of size N by encoding the information block based on a polar code of size N;
selecting k bit positions from among N bit positions in the bit sequence based on a predetermined puncturing pattern;
selecting k intermediate bit values from among intermediate bit values generated during the encoding of the information block based on the polar code of size N, based on a predetermined extension pattern;

generating a codeword of size N by replacing bit values at the k bit positions in the bit sequence with the k intermediate bit values;

performing rate matching on the codeword based on a radio resource allocated for transmission of the codeword and a target code rate; and

transmitting the rate-matched codeword over a physical channel using the radio resource.

6. A computer-readable non-volatile storage medium configured to store at least one program code comprising instructions that, when executed, cause at least one processor to perform operations comprising:

generating an information block of size K;

determining a bit sequence of size N by encoding the information block based on a polar code of size N;

selecting k bit positions from among N bit positions in the bit sequence based on a predetermined puncturing pattern;

selecting k intermediate bit values from among intermediate bit values generated during the encoding of the information block based on the polar code of size N, based on a predetermined extension pattern; and

generating a codeword of size N by replacing bit values at the k bit positions in the bit sequence with the k intermediate bit values.

7. A method of decoding an encoded information block by a communication device in a wireless communication system, the method comprising:

receiving the encoded information block; and

determining an information block of size K by decoding the encoded information block based on a polar code of size N, a predetermined puncturing pattern, and a predetermined extension pattern,

wherein the predetermined puncturing pattern is used to select k bit positions from among N bit positions in a bit sequence of size N, which is generated based on the polar code of size N and the information block of size K,

wherein the predetermined extension pattern is used to select k intermediate bit values from among intermediate bit values generated during the encoding of the information block of size N into the bit sequence,

wherein the encoded information block is obtained from a codeword generated by replacing bit values at the k bit positions in the bit sequence with the k intermediate bit values,

wherein the encoded information block is received over a physical channel using a radio resource allocated for the reception of the encoded information block, and

wherein the encoded information block includes a codeword rate-matched based on the radio resource and a target code rate.

8. A communication device configured to decode an encoded information block in a wireless communication system, the communication device comprising:

at least one transceiver;

at least one processor; and

at least one computer memory operably connected to the at least one processor and storing instructions that, when executed, cause the at least one processor to perform operations comprising:

receiving the encoded information block; and

determining an information block of size K by decoding the encoded information block based on a polar code of size N, a predetermined puncturing pattern, and a predetermined extension pattern,

wherein the predetermined puncturing pattern is used to select k bit positions from among N bit positions in a bit sequence of size N, which is generated based on the polar code of size N and the information block of size K,

wherein the predetermined extension pattern is used to select k intermediate bit values from among intermediate bit values generated during the encoding of the information block of size N into the bit sequence,

wherein the encoded information block is obtained from a codeword generated by replacing bit values at the k bit positions in the bit sequence with the k intermediate bit values,

wherein the encoded information block is received over a physical channel using a radio resource allocated for the reception of the encoded information block, and

wherein the encoded information block includes a codeword rate-matched based on the radio resource and a target code rate.

FIG. 1

1

EP 4 648 316 A1

# FIG. 2

# FIG. 3

# FIG. 4

## FIG. 5

Transport Block (TB)

```
          ◯
          │
          ▼
┌─────────────────────┐
│  TB CRC Attachment   │
└─────────────────────┘
          │
          ▼
┌─────────────────────┐
│  Code Block (CB)     │
│  Segmentation        │
└─────────────────────┘
          │
          ▼
┌─────────────────────┐
│  CB CRC Attachment   │
└─────────────────────┘
          │
          ▼
┌─────────────────────┐
│  Channel Coding      │
└─────────────────────┘
          │
          ▼
┌─────────────────────┐
│  Rate Matching       │
└─────────────────────┘
          │
          ▼
┌─────────────────────┐
│  CBs Concatenation   │
└─────────────────────┘
          │
          ▼
          ◯
```

## FIG. 6

(a)

$$F = \begin{bmatrix} 1 & 0 \\ 1 & 1 \end{bmatrix}$$

(b)

# FIG. 7

Original channels
(uniform)

New channels
(polarized)

W

W₁

Vector
channel

W_vec

⋮

⋮

W

W_{N-1}

W

W_N

Combine

Split

(a)

U₁ → G_N → X₁ → W → Y₁

U₂ → X₂ → W → Y₂

⋮ → X_N → W → Y_N

U_N →

W_vec

(b)

# FIG. 8

$W_N$

**FIG. 9**

# FIG. 10

$C(W_i)$     Rank

0.0039    8    frozen    $u_1$     $x_1$   W   $y_1$    $x_1 = \sum_{i=1}^{8} u_i$

0.1211    7    frozen    $u_2$     $x_2$   W   $y_2$    $x_2 = u_2 \oplus u_4 \oplus u_6 \oplus u_8$

0.1914    6    frozen    $u_3$     $x_3$   W   $y_3$    $x_3 = u_3 \oplus u_4 \oplus u_7 \oplus u_8$

0.6836    5    data    $u_4$     $x_4$   W   $y_4$    $x_4 = u_4 \oplus u_8$

0.3164    4    frozen    $u_5$     $x_5$   W   $y_5$    $x_5 = u_5 \oplus u_6 \oplus u_7 \oplus u_8$

0.8086    3    data    $u_6$     $x_6$   W   $y_6$    $x_6 = u_6 \oplus u_8$

0.8789    2    data    $u_7$     $x_7$   W   $y_7$    $x_7 = u_7 \oplus u_8$

0.9961    1    data    $u_8$     $x_8$   W   $y_8$    $x_8 = u_8$

EP 4 648 316 A1

45

## FIG. 11

## FIG. 12

Left cyclic shift upon encoding each bit

# FIG. 13

$c_0,c_1,c_2,c_3,...,c_{K-1}$

Channel encoder

Coded bits $d_0,d_1,d_2,d_3,...,d_{N-1}$

Sub-block

| Sub-block interleaver | Sub-block interleaver | ... | Sub-block interleaver | Sub-block interleaver |

Interleaved coded bits $y_0,y_1,y_2,y_3,...,y_{N-1}$

Circular buffer

RV1   RV2

RV0  RV3

# FIG. 14

Polar code $\mathcal{C}$ $\xrightarrow{(N,K)}$ Puncturing $\ell$ bits $\xrightarrow{(N-\ell,K)}$ Extending $\ell$ bits $\xrightarrow{(N,K)}$ Modified Polar code $\mathcal{C}'$

# FIG. 15

(a)

(b)

# FIG. 16

# FIG. 17

**FIG. 18**

**FIG. 19**

**FIG. 20**

# FIG. 21

$\min \text{WER}_{\text{SC}}(\mathcal{C}_1)$

$\min(\text{WER}_{\text{SC}}(\mathcal{C}_1) + \text{WER}_{\text{SC}}(\mathcal{C}_2))$

$\min(\text{WER}_{\text{SC}}(\mathcal{C}_1) + \text{WER}_{\text{SC}}(\mathcal{C}_2) + \text{WER}_{\text{SC}}(\mathcal{C}_3))$

$\ell_1 = \ell_{\max}$ — $\mathcal{C}_1$

$\ell_2$ — $\mathcal{C}_2$

$\ell_3$ — $\mathcal{C}_3$

No. Extending Bits $\ell$

$1 \qquad \ell_{\max} - \ell_2 \qquad \ell_{\max} - \ell_3 \qquad \ell_{\max}$

**FIG. 22**

EP 4 648 316 A1

# FIG. 23

Information block of size K

○

↓

| Perform encoding based on polar code of size N | ⌇ S2301 |

↓ Bit sequence of size N

| Determine k puncturing bits based on puncturing pattern | ⌇ S2303 |

↓

| Determine k extension bits based on extension pattern | ⌇ S2304 |

↓

| Replace k puncturing bits in bit sequence of size N with k extension bit | ⌇ S2305 |

↓ Codeword of size N

○

# FIG. 24

○

↓

| Receive encoded information block | ⌇ S2401 |

↓ Bit sequence of size N

| Perform decoding based on polar code of size N, puncturing pattern, and extension pattern | ⌇ S2403 |

↓ Information block of size K

○

## INTERNATIONAL SEARCH REPORT

| International application No. |
| --- |
| **PCT/KR2023/000002** |

| A. | CLASSIFICATION OF SUBJECT MATTER |
| --- | --- |

**H04L 1/00**(2006.01)i

According to International Patent Classification (IPC) or to both national classification and IPC

| B. | FIELDS SEARCHED |
| --- | --- |

Minimum documentation searched (classification system followed by classification symbols)

H04L 1/00(2006.01); H03M 13/00(2006.01); H03M 13/13(2006.01); H04L 1/16(2006.01); H04L 1/18(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: information block, polar code, bit sequence, puncturing pattern, extending pattern, rate matching, codeword

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| A | US 2020-0204301 A1 (QUALCOMM INCORPORATED) 25 June 2020 (2020-06-25) See paragraphs [0005] and [0094]-[0098]; and claim 1. | 1-8 |
| A | US 2020-0274644 A1 (QUALCOMM INCORPORATED) 27 August 2020 (2020-08-27) See paragraph [0048]; and claim 1. | 1-8 |
| A | US 2022-0123862 A1 (HUAWEI TECHNOLOGIES CO., LTD.) 21 April 2022 (2022-04-21) See paragraphs [0080]-[0109]; and figure 2. | 1-8 |
| A | US 2019-0158222 A1 (HUAWEI TECHNOLOGIES CO., LTD.) 23 May 2019 (2019-05-23) See paragraphs [0039]-[0071]; and claim 1. | 1-8 |
| A | US 2019-0081646 A1 (HUAWEI TECHNOLOGIES CO., LTD.) 14 March 2019 (2019-03-14) See paragraphs [0070]-[0071]; and figures 5-6. | 1-8 |

☐ Further documents are listed in the continuation of Box C.      ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **26 September 2023** | **26 September 2023** |

| Name and mailing address of the ISA/KR | Authorized officer |
| --- | --- |
| **Korean Intellectual Property Office** <br> **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/000002**

| Patent document cited in search report | | | Publication date (day/month/year) | Patent family member(s) | | | Publication date (day/month/year) |
|---|---|---|---|---|---|---|---|
| US | 2020-0204301 | A1 | 25 June 2020 | CN | 111095831 | A | 01 May 2020 |
| | | | | EP | 3673592 | A1 | 01 July 2020 |
| | | | | EP | 3673592 | B1 | 19 July 2023 |
| | | | | EP | 4228179 | A1 | 16 August 2023 |
| | | | | US | 11438100 | B2 | 06 September 2022 |
| | | | | WO | 2019-036867 | A1 | 28 February 2019 |
| US | 2020-0274644 | A1 | 27 August 2020 | CN | 108604903 | A | 28 September 2018 |
| | | | | CN | 108604903 | B | 24 August 2021 |
| | | | | EP | 3408940 | A1 | 05 December 2018 |
| | | | | US | 10749633 | B2 | 18 August 2020 |
| | | | | US | 11309997 | B2 | 19 April 2022 |
| | | | | US | 2018-0375615 | A1 | 27 December 2018 |
| | | | | WO | 2017-127973 | A1 | 03 August 2017 |
| | | | | WO | 2017-128700 | A1 | 03 August 2017 |
| US | 2022-0123862 | A1 | 21 April 2022 | CN | 112152754 | A | 29 December 2020 |
| | | | | CN | 112152754 | B | 28 December 2021 |
| | | | | EP | 3979530 | A1 | 06 April 2022 |
| | | | | WO | 2020-259222 | A1 | 30 December 2020 |
| US | 2019-0158222 | A1 | 23 May 2019 | CN | 109075803 | A | 21 December 2018 |
| | | | | CN | 109075803 | B | 06 November 2020 |
| | | | | EP | 3469714 | A1 | 17 April 2019 |
| | | | | EP | 3469714 | B1 | 30 December 2020 |
| | | | | US | 10784992 | B2 | 22 September 2020 |
| | | | | WO | 2018-021925 | A1 | 01 February 2018 |
| US | 2019-0081646 | A1 | 14 March 2019 | CN | 109155634 | A | 04 January 2019 |
| | | | | CN | 109155634 | B | 20 June 2023 |
| | | | | EP | 3375098 | A1 | 19 September 2018 |
| | | | | EP | 3375098 | B1 | 30 November 2022 |
| | | | | US | 10541710 | B2 | 21 January 2020 |
| | | | | WO | 2017-194133 | A1 | 16 November 2017 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. ARIKAN**. Channel Polarization: A Method for Constructing Capacity-Achieving Codes for Symmetric Binary-Input Memoryless Channels. *IEEE Transactions on Information Theory*, July 2009, vol. 55 (7), 3051-3073
- **I. TAL** ; **A. VARDY**. List decoding of polar codes. *Proc. IEEE Int. Symp. Inf. Theory*, July 2011, 1-5
- **P. YUAN** ; **T. PRINZ** ; **G. BOECHERER** ; **O. ISCAN** ; **R. BOEHNKE** ; **W. XU**. Polar Code Construction for List Decoding. *SCC 2019; 12th International ITG Conference on Systems, Communications and Coding*, 2019, 1-6

- **D. WU** ; **Y. LI** ; **Y. SUN**. Construction and Block Error Rate Analysis of Polar Codes Over AWGN Channel Based on Gaussian Approximation. *IEEE Communications Letters*, July 2014, vol. 18 (7), 1099-1102
- **P. TRIFONOV** ; **V. MILOSLAVSKAYA**. Polar Subcodes. *IEEE Journal on Selected Areas in Communications*, February 2016, vol. 34 (2), 254-266